# EUROPEAN PATENT SPECIFICATION

(11) **EP 2 820 590 B1**
(45) Date of publication and mention of the grant of the patent: **24.04.2019**
(21) Application number: 13858834.8
(22) Date of filing: 01.03.2013
(51) Int. Cl.: G06F 3/0488, G06F 3/02

(54) **KEY STRIKE DETERMINATION FOR PRESSURE SENSITIVE KEYBOARD**
TASTENANSCHLAGBESTIMMUNG FÜR DRUCKEMPFINDLICHE TASTATUR
DÉTERMINATION DE FRAPPE DE TOUCHE POUR UN CLAVIER SENSIBLE À LA PRESSION

(30) Priority: 02.03.2012 US 201261606321 P; 02.03.2012 US 201261606301 P; 02.03.2012 US 201261606313 P; 02.03.2012 US 201261606333 P; 02.03.2012 US 201261606336 P; 06.03.2012 US 201261607451 P; 21.03.2012 US 201261613745 P; 14.05.2012 US 201213471393
(43) Date of publication of application: 07.01.2015
(73) Proprietor: Microsoft Technology Licensing, LLC, Redmond, WA 98052 (US)
(72) Inventor: DRASNIN, Sharon, Redmond, Washington 98052-6399 (US); MAIL, Scott Mitchel, Redmond, Washington 98052-6399 (US); BELESIU, Jim Tom, Redmond, Washington 98052-6399 (US); SHAW, Timothy C., Redmond, Washington 98052-6399 (US); LUTZ, Moshe R., Redmond, Washington 98052-6399 (US); DIETZ, Paul Henry, Redmond, Washington 98052-6399 (US); WHITT, III, David Otto, Redmond, Washington 98052-6399 (US); MCLAUGHLIN, Robyn Rebecca Reed, Redmond, Washington 98052-6399 (US); SCHNEIDER, Summer L., Redmond, Washington 98052-6399 (US); WAHL, Eric Joseph, Redmond, Washington 98052-6399 (US); WISE, James H., Redmond, Washington 98052-6399 (US); LEON, Camilo, Redmond, Washington 98052-6399 (US); AAGAARD, Karsten, Redmond, Washington 98052-6399 (US); OLIVER, Thomas Charles, Redmond, Washington 98052-6399 (US); CADY, Andrew N., Redmond, Washington 98052-6399 (US); SCHULTZ, Bernard Maurice, Redmond, Washington 98052-6399 (US); DIGHDE, Rajesh Manohar, Redmond, Washington 98052-6399 (US); SIDDIQUI, Kabir, Redmond, Washington 98052-6399 (US); ISHIHARA, James Alec, Redmond, Washington 98052-6399 (US); WANG, Hua, Redmond, Washington 98052-6399 (US); GROENE, Ralf, Redmond, Washington 98052-6399 (US); STOUMBOS, Christopher Harry, Redmond, Washington 98052-6399 (US); PELLEY, Joel Lawrence, Redmond, Washington 98052-6399 (US); KASSELS, Jay Scott, Redmond, Washington 98052-6399 (US); SPOONER, Richard Peter, Redmond, Washington 98052-6399 (US); MICKELSON, Matthew David, Redmond, Washington 98052-6399 (US); HUALA, Rob, Redmond, Washington 98052-6399 (US); MATHIAS, Dennis J., Redmond, Washington 98052-6399 (US); VANDERVOORT, David C., Redmond, Washington 98052-6399 (US); PLEAKE, Todd David, Redmond, Washington 98052-6399 (US); WHITMAN, Christopher A., Redmond, Washington 98052-6399 (US); OLER, Van Winston, Redmond, Washington 98052-6399 (US); UMENO, Hiroo, Redmond, Washington 98052-6399 (US); PEREK, David R., Redmond, Washington 98052-6399 (US); SCHWAGER, Michael A., Redmond, Washington 98052-6399 (US); SEILSTAD, Mark J., Redmond, Washington 98052-6399 (US); REED, Anthony Christian, Redmond, Washington 98052-6399 (US); CUMMINGS, Stephan Alexander, Redmond, Washington 98052-6399 (US); JENSEN, Darryl I., Redmond, Washington 98052-6399 (US); PANAY, Panos C., Redmond, Washington 98052-6399 (US); STRANDE, Hakon, Redmond, Washington 98052-6399 (US); GOH, Chun Beng, Redmond, Washington 98052-6399 (US); MANTOOTH, Harold F., Redmond, Washington 98052-6399 (US); MARSHALL, James Charles, Redmond, Washington 98052-6399 (US); PEDERSEN, Matthew G., Redmond, Washington 98052-6399 (US); YOUNG, Robert D., Redmond, Washington 98052-6399 (US); SHERMAN, Nathan C., Redmond, Washington 98052-6399 (US); GIBSON, Scott K., Redmond, Washington 98052-6399 (US); SYKES, Shane Aaron, Redmond, Washington 98052-6399 (US); LANE, David M., Redmond, Washington 98052-6399 (US); OBIE, Gene Robert, Redmond, Washington 98052-6399 (US); GIAIMO, III, Edward C., Redmond, Washington 98052-6399 (US); NEFF, David, Redmond, Washington 98052-6399 (US); SOUSA, Jose R., Redmond, Washington 98052-6399 (US)
(74) Representative: Goddar, Heinz J.
(86) International application number: PCT/US2013/028487
(87) International publication number: WO 2014/084877

(56) References cited:
- GB-A- 2 381 584
- JP-A- 2010 244 514
- KR-A- 20110 120 002
- US-A- 5 053 585
- US-A- 5 995 026
- US-A1- 2003 011 576
- US-A1- 2010 265 182
- US-A1- 2011 050 576
- US-A1- 2011 248 941
- US-A1- 2011 285 555

## Description

### BACKGROUND

Mobile computing devices have been developed to increase the functionality that is made available to users in a mobile setting. For example, a user may interact with a mobile phone, tablet computer, or other mobile computing device to check email, surf the web, compose texts, interact with applications, and so on. However, traditional mobile computing devices often employed a virtual keyboard that was accessed using touchscreen functionality of the device. This was generally employed to maximize an amount of display area of the computing device.

Use of the virtual keyboard, however, could be frustrating to a user that desired to provide a significant amount of inputs, such as to enter a significant amount of text to compose a long email, document, and so forth. Thus, conventional mobile computing devices were often perceived to have limited usefulness for such tasks, especially in comparison with the ease at which users could enter text using a conventional keyboard, e.g., of a conventional desktop computer. Use of the conventional keyboards, though, with the mobile computing device could decrease the mobility of the mobile computing device and thus could make the mobile computing device less suited for its intended use in mobile settings.

US 5 995 026 A discloses a method comprising obtaining an indication of pressure applied to a key of a pressure sensitive keyboard configured to by physically and communicatively removable from a computing device and determining that the pressure applied to the key is a key strike in response to the pressure applied to the key rising to a key press threshold amount.

### SUMMARY

The present invention provides a method according to claim 1. The dependent claims relate to special embodiments thereof.

### BRIEF DESCRIPTION OF THE DRAWINGS

The detailed description is described with reference to the accompanying figures. In the figures, the left-most digit(s) of a reference number identifies the figure in which the reference number first appears. The use of the same reference numbers in different instances in the description and the figures may indicate similar or identical items. Entities represented in the figures may be indicative of one or more entities and thus reference may be made interchangeably to single or plural forms of the entities in the discussion.
FIG. 1 is an illustration of an environment in an example implementation that is operable to employ the techniques described herein.
FIG. 2 depicts an example implementation of an input device of FIG. 1 as showing a flexible hinge in greater detail.
FIG. 3 depicts an example implementation showing a perspective view of a connecting portion of FIG. 2 that includes mechanical coupling protrusions and a plurality of communication contacts.
FIG. 4 depicts an example of a cross-sectional view of a pressure sensitive key of a keyboard of the input device of FIG. 2.
FIG. 5 depicts an example of a pressure sensitive key of FIG. 4 as having pressure applied at a first location of a flexible contact layer to cause contact with a corresponding first location of a sensor substrate. [0013] FIG. 6 depicts an example of the pressure sensitive key of FIG. 4 as having pressure applied at a second location of the flexible contact layer to cause contact with a corresponding second location of the sensor substrate.
FIG. 6 depicts an example of the pressure sensitive key of FIG. 4 as having pressure applied at a second location of the flexible contact layer to cause contact with a corresponding second location of the sensor substrate.
FIG. 7 depicts an example of a pressure sensitive key of FIG. 4 as employing a force concentrator layer.
FIG. 8 an example of the pressure sensitive key of FIG. 7 as having pressure applied at a plurality of different locations of the force concentrator layer to cause a flexible contact layer to contact a sensor substrate.
FIG. 9A illustrates an example of a view of a cross section of a keyboard that includes a plurality of pressure sensitive keys that employ the force concentrator layer.
FIG. 9B illustrates an example of a top view of the force concentrator as including one or more cuts to increase flexibility of the layer proximal to the cuts.
FIG. 10 depicts an example of a graph of pressure on one key over time illustrating a key strike.
FIG. 11 depicts an example of a graph of pressure on one key over time illustrating an invalid key press due to a same key rejection amount of time not elapsing.
FIG. 12 depicts an example of a graph of pressure on one key over time illustrating multiple key strikes of the same key.
FIG. 13 depicts an example of a graph of pressure on multiple keys over time illustrating an invalid key press due to a different key rejection amount of time not elapsing.
FIG. 14 depicts an example of a graph of pressure on multiple keys over time illustrating multiple key strikes of different keys.
FIG. 15 depicts an example of a graph of pressure on multiple keys over time illustrating multiple keys pressed at approximately the same time.
FIG. 16 depicts an example of a graph of pressure on multiple keys concurrently over time illustrating multiple key strikes resulting from concurrently pressed keys.
FIG. 17 depicts an example of a graph of pressure on multiple keys concurrently over time illustrating multiple key strikes resulting from concurrently pressed keys.
FIG. 18 depicts an example of a graph of pressure on multiple keys concurrently over time illustrating invalid key presses resulting from concurrently pressed keys.
FIG. 19 depicts an example of a graph of pressure on one key over time illustrating a key strike.
FIG. 20 depicts an example of a graph of pressure on one key over time illustrating an invalid key press.
FIG. 21 depicts an example of a graph of pressure on one key over time illustrating an invalid key press due to a same key rejection amount of time not elapsing.
FIG. 22 depicts an example of a graph of pressure on one key over time illustrating multiple key strikes of the same key.
FIG. 23 depicts an example of a graph of pressure on multiple keys over time illustrating an invalid key press due to a different key rejection amount of time not elapsing.
FIG. 24 depicts an example of a graph of pressure on multiple keys over time illustrating multiple key strikes of different keys.
FIG. 25 depicts an example of a graph of pressure on multiple keys over time illustrating multiple keys pressed at approximately the same time.
FIG. 26 depicts an example of a graph of pressure on multiple keys concurrently over time illustrating multiple key strikes resulting from concurrently pressed keys.
FIG. 27 depicts an example of a graph of pressure on multiple keys concurrently over time illustrating multiple key strikes resulting from concurrently pressed keys.
FIG. 28 depicts an example of a graph of pressure on multiple keys concurrently over time illustrating invalid key presses resulting from concurrently pressed keys.
FIG. 29 depicts an example of a graph of pressure on one key over time illustrating a key strike.
FIG. 30 depicts an example of a graph of pressure on a key over time illustrating a resting position.
FIG. 31 is an illustration of a system in an example implementation that is operable to employ the techniques described herein.
FIG. 32 is a flowchart illustrating an example process for implementing the techniques described herein in accordance with one or more embodiments.
FIG. 33 is a flowchart illustrating an example process for determining whether a key strike occurs in accordance with one or more embodiments.
FIG. 34 illustrates an example system including various components of an example device that can be implemented as any type of computing device as described with reference to FIGS. 1-33 to implement embodiments of the techniques described herein.

### DETAILED DESCRIPTION

### Overview

Key strike determination for pressure sensitive keyboard techniques are described. A pressure sensitive keyboard includes multiple pressure sensors associated with the keys of the keyboard. In response to pressure applied to one or more keys of the keyboard, a determination is made as to whether the pressure applied is a key strike (a user selection of a key). Various different factors can be used in determining whether the pressure applied is a key strike, such as the amount of the pressure applied, a rate at which the pressure is applied, a number of keys to which pressure is applied, when the pressure is applied relative to previous key strikes, and so forth.

In the following discussion, an example environment is first described that may employ the techniques described herein. Example procedures are then described which may be performed in the example environment as well as other environments. Consequently, performance of the example procedures is not limited to the example environment and the example environment is not limited to performance of the example procedures.

### Example Environment and Procedures

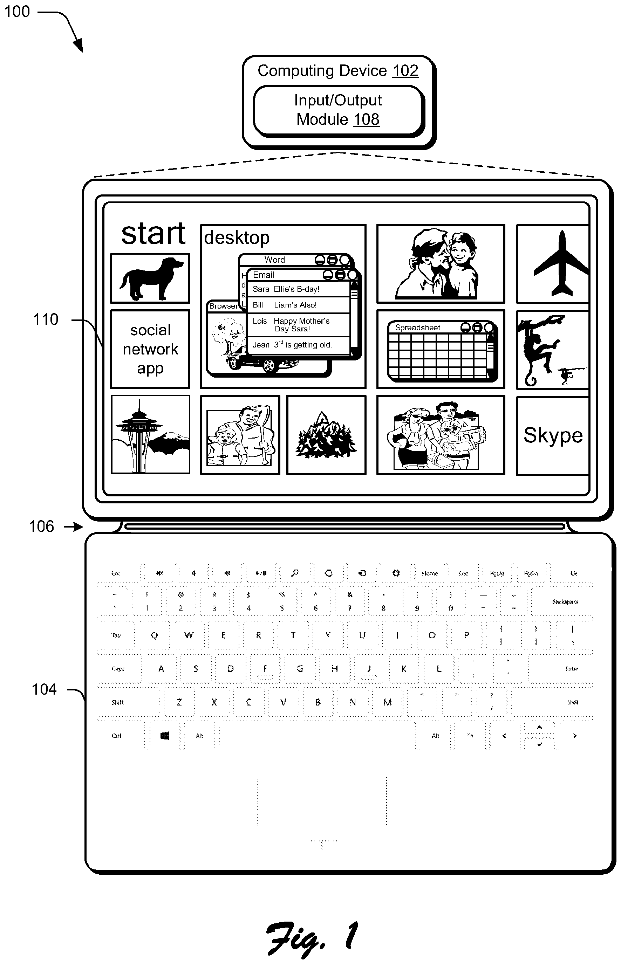

FIG. 1 is an illustration of an environment 100 in an example implementation that is operable to employ the techniques described herein. The illustrated environment 100 includes an example of a computing device 102 that is physically and communicatively coupled to an input device 104 via a flexible hinge 106. The computing device 102 may be configured in a variety of ways. For example, the computing device 102 may be configured for mobile use, such as a mobile phone, a tablet computer as illustrated, and so on. Thus, the computing device 102 may range from full resource devices with substantial memory and processor resources to a low-resource device with limited memory and/or processing resources. The computing device 102 may also relate to software that causes the computing device 102 to perform one or more operations.

The computing device 102, for instance, is illustrated as including an input/output module 108. The input/output module 108 is representative of functionality relating to processing of inputs and rendering outputs of the computing device 102. A variety of different inputs may be processed by the input/output module 108, such as inputs relating to functions that correspond to keys of the input device 104, keys of a virtual keyboard displayed by the display device 110 to identify gestures and cause operations to be performed that correspond to the gestures that may be recognized through the input device 104 and/or touchscreen functionality of the display device 110, and so forth. Thus, the input/output module 108 may support a variety of different input techniques by recognizing and leveraging a division between types of inputs including key presses, gestures, and so on.

In the illustrated example, the input device 104 is configured as a keyboard having a QWERTY arrangement of keys although other arrangements of keys are also contemplated. Further, other non-conventional configurations are also contemplated, such as a game controller, configuration to mimic a musical instrument, and so forth. Thus, the input device 104 and keys incorporated by the input device 104 may assume a variety of different configurations to support a variety of different functionality.

As previously described, the input device 104 is physically and communicatively coupled to the computing device 102 in this example through use of a flexible hinge 106. The flexible hinge 106 is flexible in that rotational movement supported by the hinge is achieved through flexing (e.g., bending) of the material forming the hinge as opposed to mechanical rotation as supported by a pin, although that embodiment is also contemplated. Further, this flexible rotation may be configured to support movement in one direction (e.g., vertically in the figure) yet restrict movement in other directions, such as lateral movement of the input device 104 in relation to the computing device 102. This may be used to support consistent alignment of the input device 104 in relation to the computing device 102, such as to align sensors used to change power states, application states, and so on.

The flexible hinge 106, for instance, may be formed using one or more layers of fabric and include conductors formed as flexible traces to communicatively couple the input device 104 to the computing device 102 and vice versa. This communication, for instance, may be used to communicate a result of a key press to the computing device 102, receive power from the computing device, perform authentication, provide supplemental power to the computing device 102, and so on. The flexible hinge 106 may be configured in a variety of ways, further discussion of which may be found in relation to the following figure.

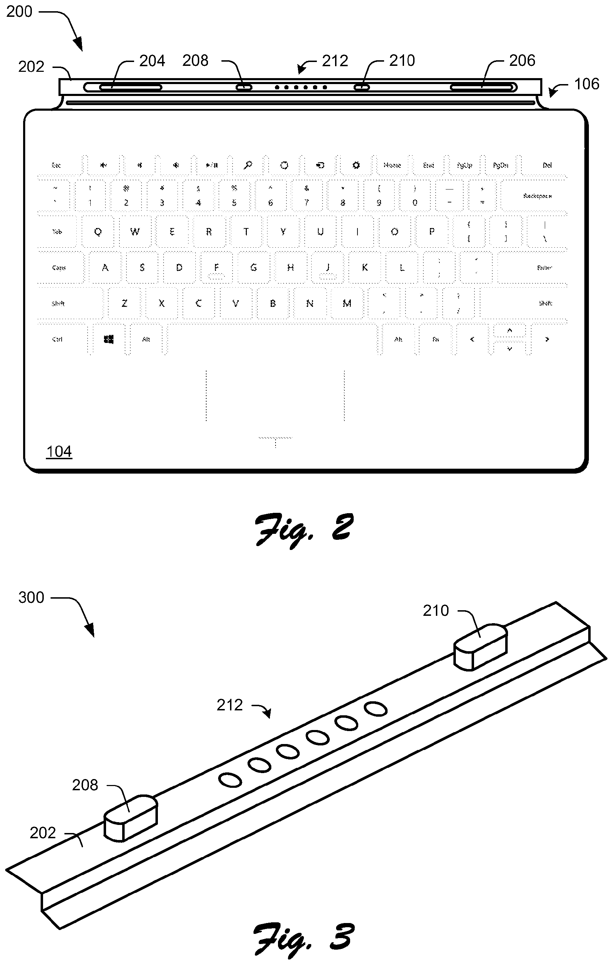

FIG. 2 depicts an example implementation 200 of the input device 104 of FIG. 1 as showing the flexible hinge 106 in greater detail. In this example, a connection portion 202 of the input device is shown that is configured to provide a communicative and physical connection between the input device 104 and the computing device 102. In this example, the connection portion 202 has a height and cross section configured to be received in a channel in the housing of the computing device 102, although this arrangement may also be reversed.

The connection portion 202 is flexibly connected to a portion of the input device 104 that includes the keys through use of the flexible hinge 106. Thus, when the connection portion 202 is physically connected to the computing device the combination of the connection portion 202 and the flexible hinge 106 supports movement of the input device 104 in relation to the computing device 102 that is similar to a hinge of a book.

For example, rotational movement may be supported by the flexible hinge 106 such that the input device 104 may be placed against the display device 110 of the computing device 102 and thereby act as a cover. The input device 104 may also be rotated so as to be disposed against a back of the computing device 102, e.g., against a rear housing of the computing device 102 that is disposed opposite the display device 110 on the computing device 102.

Naturally, a variety of other orientations are also supported. For instance, the computing device 102 and input device 104 may assume an arrangement such that both are laid flat against a surface as shown in FIG. 1. In another instance, a typing arrangement may be supported in which the input device 104 is laid flat against a surface and the computing device 102 is disposed at an angle to permit viewing of the display device 110, e.g., such as through use of a kickstand disposed on a rear surface of the computing device 102. In another instance, an arrangement may be supported in which the input device 104 is laid flat against the back side of the display device 110 with keys facing outward (in approximately the opposite direction of the display of display device 110), allowing the user to grasp the display device 110 and touch the keys of the input device 104 with his or her fingers on the backside of the display device 110 while viewing the output displayed by the display device 110. Other instances are also contemplated, such as a tripod arrangement, meeting arrangement, presentation arrangement, and so forth.

The connecting portion 202 is illustrated in this example as including magnetic coupling devices 204, 206, mechanical coupling protrusions 208, 210, and a plurality of communication contacts 212. The magnetic coupling devices 204, 206 are configured to magnetically couple to complementary magnetic coupling devices of the computing device 102 through use of one or more magnets. In this way, the input device 104 may be physically secured to the computing device 102 through use of magnetic attraction.

The connecting portion 202 also includes mechanical coupling protrusions 208, 210 to form a mechanical physical connection between the input device 104 and the computing device 102. The mechanical coupling protrusions 208, 210 are shown in greater detail in the following figure.

FIG. 3 depicts an example implementation 300 shown a perspective view of the connecting portion 202 of FIG. 2 that includes the mechanical coupling protrusions 208, 210 and the plurality of communication contacts 212. As illustrated, the mechanical coupling protrusions 208, 210 are configured to extend away from a surface of the connecting portion 202, which in this case is perpendicular although other angles are also contemplated.

The mechanical coupling protrusions 208, 210 are configured to be received within complimentary cavities within the channel of the computing device 102. When so received, the mechanical coupling protrusions 208, 210 promote a mechanical binding between the devices when forces are applied that are not aligned with an axis that is defined as correspond to the height of the protrusions and the depth of the cavity.

For example, when a force is applied that does coincide with the longitudinal axis described previously that follows the height of the protrusions and the depth of the cavities, a user overcomes the force applied by the magnets solely to separate the input device 104 from the computing device 102. However, at other angles the mechanical coupling protrusion 208, 210 are configured to mechanically bind within the cavities, thereby creating a force to resist removal of the input device 104 from the computing device 102 in addition to the magnetic force of the magnetic coupling devices 204, 206. In this way, the mechanical coupling protrusions 208, 210 may bias the removal of the input device 104 from the computing device 102 to mimic tearing a page from a book and restrict other attempts to separate the devices.

The connecting portion 202 is also illustrated as including a plurality of communication contacts 212. The plurality of communication contacts 212 is configured to contact corresponding communication contacts of the computing device 102 to form a communicative coupling between the devices. The communication contacts 212 may be configured in a variety of ways, such as through formation using a plurality of spring loaded pins that are configured to provide a consistent communication contact between the input device 104 and the computing device 102. Therefore, the communication contact may be configured to remain during minor movement of jostling of the devices. A variety of other examples are also contemplated, including placement of the pins on the computing device 102 and contacts on the input device 104.

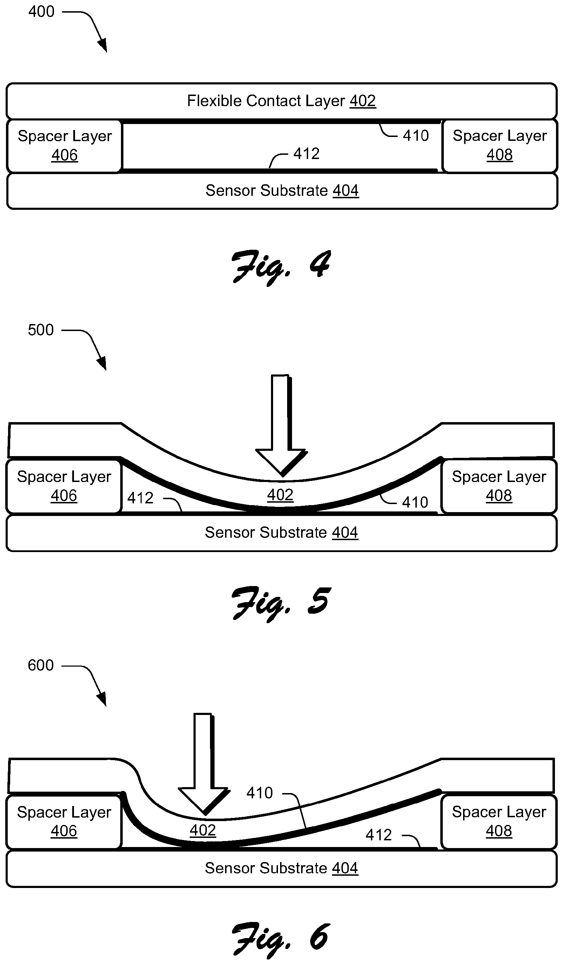

FIG. 4 depicts an example of a cross-sectional view of a pressure sensitive key 400 of a keyboard of the input device 104 of FIG. 2. The pressure sensitive key 400 in this example is illustrated as being formed using a flexible contact layer 402 (e.g., Mylar) that is spaced apart from the sensor substrate 404 using a spacer layer 406, 408, which may be formed as another layer of Mylar or other bendable material, formed on the sensor substrate 404, and so on. In this example, the flexible contact layer 402 does not contact the sensor substrate 404 absent application of pressure against the flexible contact layer 402.

The flexible contact layer 402 in this example includes a force sensitive ink 410 disposed on a surface of the flexible contact layer 402 that is configured to contact the sensor substrate 404. The force sensitive ink 410 is configured such that an amount of resistance of the ink varies directly in relation to an amount of pressure applied. The force sensitive ink 410, for instance, may be configured with a relatively rough surface that is compressed against the sensor substrate 404 upon an application of pressure against the flexible contact layer 402. The greater the amount of pressure, the more the force sensitive ink 410 is compressed, thereby increasing conductivity and decreasing resistance of the force sensitive ink 410. Other conductors may also be disposed on the flexible contact layer 402 including other types of pressure sensitive and non-pressure sensitive conductors.

The sensor substrate 404 includes one or more conductors 412 disposed thereon that are configured to be contacted by the force sensitive ink 410 of the flexible contact layer 402. When contacted, an analog signal may be generated for processing by the input device 104 and/or the computing device 102, e.g., to recognize whether the signal is likely intended by a user to provide an input for the computing device 102. A variety of different types of conductors 412 may be disposed on the sensor substrate 404, such as formed from a variety of conductive materials (e.g., silver, copper), disposed in a variety of different configurations such as inter-digitated trace fingers, and so on.

FIG. 5 depicts an example 500 of the pressure sensitive key 400 of FIG. 4 as having pressure applied at a first location of the flexible contact layer 402 to cause contact of the force sensitive ink 410 with a corresponding first location of the sensor substrate 404. The pressure is illustrated through use of an arrow in FIG. 5 and may be applied in a variety of ways, such as by a finger of a user's hand, stylus, pen, and so on. In this example, the first location at which pressure is applied as indicated by the arrow is located generally near a center region of the flexible contact layer 402 that is disposed between the spacer layers 406, 408. Due to this location, the flexible contact layer 402 may be considered generally flexible and thus responsive to the pressure.

This flexibility permits a relatively large area of the flexible contact layer 402, and thus the force sensitive ink 410, to contact the conductors 412 of the sensor substrate 404. Thus, a relatively strong signal may be generated. Further, because the flexibility of the flexible contact layer 402 is relatively high at this location, a relatively large amount of the force may be transferred through the flexible contact layer 402, thereby applying this pressure to the force sensitive ink 410. As previously described, this increase in pressure may cause a corresponding increase in conductivity of the force sensitive ink and decrease in resistance of the ink. Thus, the relatively high amount of flexibility of the flexible contact layer at the first location may cause a relatively stronger signal to be generated in comparison with other locations of the flexible contact layer 402 that located closer to an edge of the key, an example of which is described in relation to the following figure.

FIG. 6 depicts an example 600 of the pressure sensitive key 400 of FIG. 4 as having pressure applied at a second location of the flexible contact layer 402 to cause contact with a corresponding second location of the sensor substrate 404. In this example, the second location of FIG. 6 at which pressure is applied is located closer to an edge of the pressure sensitive key (e.g., closer to an edge of the spacer layer 406) than the first location of FIG. 5. Due to this location, the flexible contact layer 402 has reduced flexibility when compared with the first location and thus less responsive to pressure.

This reduced flexibility may cause a reduction in an area of the flexible contact layer 402, and thus the force sensitive ink 410, that contacts the conductors 412 of the sensor substrate 404. Thus, a signal produced at the second location may be weaker than a signal produced at the first location of FIG. 5.

Further, because the flexibility of the flexible contact layer 402 is relatively low at this location, a relatively low amount of the force may be transferred through the flexible contact layer 402, thereby reducing the amount of pressure transmitted to the force sensitive ink 410. As previously described, this decrease in pressure may cause a corresponding decrease in conductivity of the force sensitive ink and increase in resistance of the ink in comparison with the first location of FIG. 5. Thus, the reduced flexibility of the flexible contact layer 402 at the second location in comparison with the first location may cause a relatively weaker signal to be generated. Further, this situation may be exacerbated by a partial hit in which a smaller portion of the user's finger is able to apply pressure at the second location of FIG. 6 in comparison with the first location of FIG. 5.

Force concentrator layer techniques may be employed to improve consistency of the contact of the flexible contact layer 402 with the sensor substrate 404 as well as other features, further discussion of which may be found in relation to the following figure.

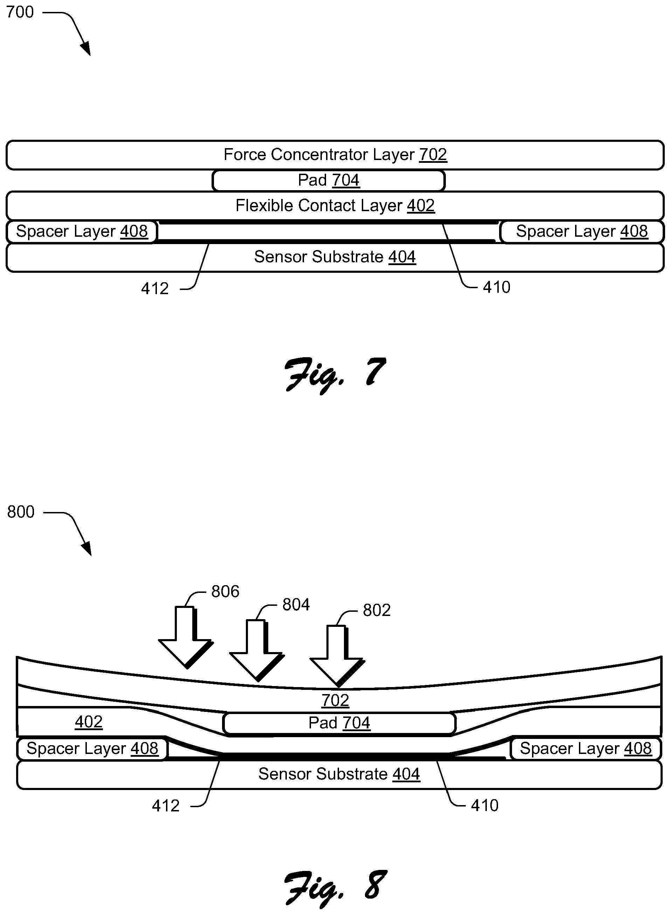

FIG. 7 depicts an example 700 of a pressure sensitive key of FIG. 4 as employing a force concentrator layer 702. The force concentrator layer 702 may be configured from a variety of materials, such as a flexible material (e.g., Mylar) that is capable of flexing against the flexible contact layer 402.

The force concentrator layer 702 in this instance includes a pad 704 disposed thereon that is raised from a surface of the force concentrator layer 702. Thus, the pad 704 is configured as a protrusion to contact the flexible contact layer 402. The pad 704 may be formed in a variety of ways, such as formation as a layer (e.g., printing, deposition, forming, etc.) on a substrate of the force concentrator layer 702 (e.g., Mylar), as an integral part of the substrate itself, and so on.

FIG. 8 depicts an example 800 of the pressure sensitive key 700 of FIG. 7 as having pressure applied at a plurality of different locations of the force concentrator layer 702 to cause the flexible contact layer 402 to contact the sensor substrate 404. The pressure is again illustrated through use of arrow, which in this instance include first, second, and third locations 802, 804, 806 which are positioned at distances that are respectively closer to an edge of the key, e.g., an edge defined by the spacer layer 406, 408.

As illustrated, the pad 704 is sized so as to permit the flexible contact layer 402 to flex between the spacer layer 406, 408. The pad 704 is configured to provide increased mechanical stiffness and thus improved resistance to bending and flexing, e.g., as in comparison with a substrate (e.g., Mylar) of the force concentrator layer 702. Therefore, when the pad 704 is pressed against the flexible contact layer 402, the flexible contact layer 402 has a decreased bend radius as is illustrated through comparison of FIG. 8 with FIGS. 5 and 6.

Thus, the bending of the flexible contact layer 402 around the pad 704 may promote a relatively consistent contact area between the force sensitive ink 410 and the conductors 412 of the sensor substrate 404. This may promote normalization of a signal produced by the key.

The pad 704 may also act to spread a contact area of a source of the pressure. A user, for example, may press against the force concentrator layer 702 using a fingernail, a tip of a stylus, pen, or other object that has a relatively small contact area. As previously described this could result in correspondingly small contact area of the flexible contact layer 402 that contacts the sensor substrate 404, and thus a corresponding decrease in signal strength.

However, due to the mechanical stiffness of the pad 704, this pressure may be spread across an area of the pad 704 that contacts the flexible contact layer 402, which is then spread across an area of the flexible contact layer 402 that correspondingly bends around the pad 704 to contact the sensor substrate 404. In this way, the pad 704 may be used to normalize a contact area between the flexible contact layer 402 and the sensor substrate 404 that is used to generate a signal by the pressure sensitive key.

The pad 704 may also act to channel pressure, even if this pressure is applied "off center." As previously described in relation to FIGS. 5 and 6, the flexibility of the flexible contact layer 402 may depend at least partially on a distance from an edge of the pressure sensitive key, e.g., an edge defined by the spacer layer 406, 408 in this instance.

The pad 704, however, may be used to channel pressure to the flexible contact layer 402 to promote relatively consistent contact. For example, pressure applied at a first location 802 that is positioned at a general center region of the force concentrator layer 702 may cause contact that is similar to contact achieved when pressure applied at a second location 804 that is positioned at an edge of the pad 704. Pressures applied outside of a region of the force concentrator layer 702 defined by the pad 704 may also be channeled through use of the pad 704, such as a third position 806 that is located outside of the region defined by the pad 704 but within an edge of the key. A position that is located outside of a region of the force concentrator layer 702 defined by the spacer layer 406, 408 may also be channeled to cause the flexible contact layer 402 to contact the sensor substrate 404, an example of which is defined in relation to the following figure.

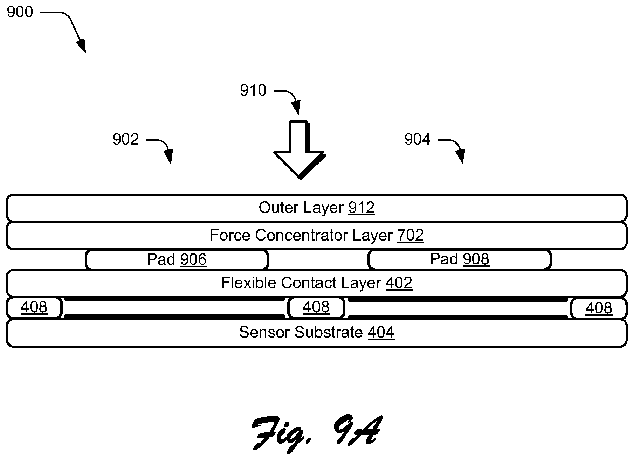

FIG. 9A illustrates an example of a view of a cross section of a keyboard 900 that includes a plurality of pressure sensitive keys that employ the force concentrator layer. The keyboard 900 in this example includes first and second pressure sensitive keys 902, 904. The pressure sensitive keys 902, 904 share a force concentrator layer 702, a flexible contact layer 402, a sensor substrate 404, and a spacer layer 408 as before. Each of the pressure sensitive keys 902, 904 in this example has a respective pad 906, 908 that is configured to channel pressure to cause contact between a respective portion of the flexible contact layer 402 and sensor substrate 404.

As previously described, limited flexibility at the edges of conventional pressure sensitive keys could result in an inability of the keys to recognize pressure applied at the edges of the keys. This could cause "dead zones" in which the input device 104 could not recognize applied pressures. However, through use of the force concentrator layer 702 and channeling of pressure supported by the pads 906, 908 the existence of dead zones may be reduced and even eliminated.

For example, a location 910 is illustrated through use of an arrow that is disposed between the first and second pressure sensitive keys 902, 904. In this instance, the location 910 is disposed over the spacer layer 408 and closer to the first pressure sensitive key 902 than the second pressure sensitive key 904.

Accordingly, the pad 906 of the first pressure sensitive key 902 may channel a greater amount of the pressure than the pad 908 of the second pressure sensitive key 904. This may result in a stronger signal being produce by the first pressure sensitive key 902 than the second pressure sensitive key 904, a signal being generated at just the first pressures sensitive key 902 and not the second pressure sensitive key 904, and so forth. Regardless, modules of the input device 104 and/or the computing device 102 may then determine a likely intent of a user regarding which of the keys is to be employed by processing the signals generated by the keys. In this way, the force concentrator layer 702 may mitigate against dead zones located between the keys by increasing an area that may be used to activate the key through channeling.

The force concentrator layer 702 may also be used to perform mechanical filtering of pressures applied against the keys. A user, for instance, when typing a document may choose to rest one or more fingers of a hand against a surface of the keys but not wish to activate the key. Without the force concentrator layer 702, therefore, processing of inputs from the pressure sensitive keys may be complicated by determining whether an amount and/or duration of pressure applied to the key is likely intended to activate the key.

However, in this example the force concentrator layer 702 may be configured for use with the flexible contact layer to mechanically filter inputs that are not likely to be intended by a user to activate the key. The force concentrator layer 702, for instance, may be configured to employ a threshold that in combination with the flexible contact layer 402 defines an amount of pressure to be employed to actuate the key. This may include an amount of pressure that is sufficient to cause the flexible contact layer 402 and the force sensitive ink 410 disposed thereon to contact conductors 412 of the sensor substrate to generate a signal that is recognizable as an input by the input device 104 and/or computing device 102.

In an implementation, this threshold is set such that a pressure of approximately fifty grams or less is not sufficient to cause the force concentrator layer 702 and the flexible contact layer 402 to initiate the signal whereas pressures above that threshold are recognizable as inputs. A variety of other implementations and thresholds are also contemplated that may be configured to differentiate against a resting pressure and a key strike.

The force concentrator layer 702 may also be configured to provide a variety of other functionality. The input device 104, for instance, may include an outer layer 912 (e.g., fabric, microfiber, and so on) on which indications of operations of respective keys, e.g., letters, numbers, and other operations such as "shift," "return," navigation, and so on. The force concentrator layer 702 may be disposed beneath this layer. Further, a side of the force concentrator layer 702 that is exposed towards the outer layer 912 may be configured to be substantially smooth, thereby reducing and even eliminating witness lines that could result from underlying components of the input device 104.

In this way, a surface of the outer layer 912 may be made with increased uniformity and thus provided a better typing experience with increased accuracy, e.g., by promoting a smooth tactile feel without interference from underlying components. The force concentrator layer 702 may also be configured to protect against electrostatic discharge (ESD) to underlying components of the input device 104. For example, the input device 104 may include a track pad as illustrated in FIGS. 1 and 2 and thus movement across the track pad may generate static. The force concentrator layer 702, however, may protect components of the input device 104 that are exposed beneath the layer from this potential ESD.

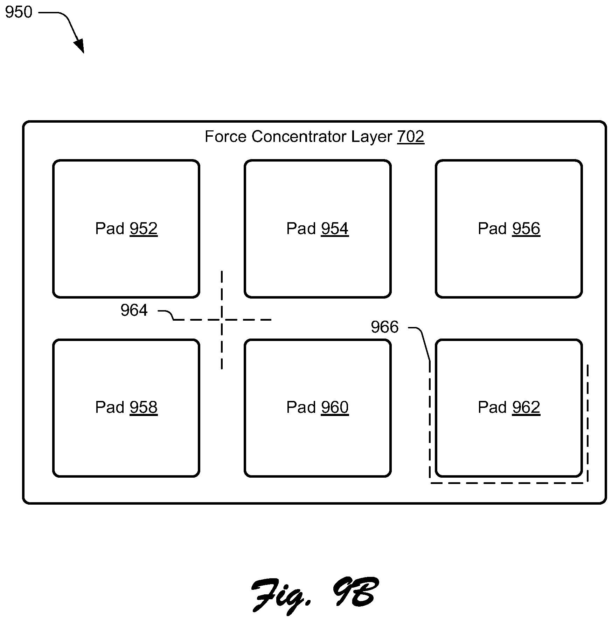

FIG. 9B illustrates an example of a top view 950 of the force concentrator as including one or more cuts to increase flexibility of the layer proximal to the cuts. The force concentrator layer 702 in this example includes a plurality of pads 952, 954, 956, 958, 960, 962 as previously described. However, in this example the force concentrator layer includes a plurality of cuts to improve an ability of the layer to move proximal to the cuts.

In a first example, a set of cuts 964 are made at least partially into or through the force concentrator layer 702 to corners of a plurality of respective pads 952, 954, 958, 960. Accordingly, movement of the force concentrator layer 702 proximal to those cuts at the corners of the pads may be changed to include cantilever movement as well as deflection. Thus, by "freeing" portions of the force concentrator layer 702, sensitivity may be increased as desired such as at edges of corresponding keys.

Naturally, a variety of different configurations of cuts are contemplated. For example, as previously described different keys of a keyboard may be configured to address "how" a user is to press the keys. For example, pad 962 may correspond to a key on a bottom row, a track pad, and so on. Accordingly, cuts 966 may be disposed along a plurality of sides to free the force concentrator layer 702 for cantilevered movement. A variety of other examples are also contemplated.

Regardless of whether the force concentrator layer techniques are used, an indication of the pressure applied to a key is generated (e.g., by the sensor substrate 404 generates). This pressure can be applied by a user's finger, stylus, and so forth as discussed above. This indication of pressure is typically measured in grams, although other units of measure are contemplated.

The pressure applied to keys as well as the duration of the pressure applied to keys is used to determine which keys of the keyboard of the input device 104 of FIG. 2 are key strikes by the user. A key strike refers to user selection of a key (e.g., a key for the letter "s" is struck if the user desires to input a value of "s" to the device). The keys are pressure sensitive, and thus the keyboard is also referred to as a pressure sensitive keyboard. This determination can be performed in the input device 104 and/or the computing device 102 of FIG. 1. For example, this determination can be made by the input/output module 108 of FIG. 1 and/or a key recognition module included in the input device 104.

The pressures applied to the keys of the keyboard are sensed at a particular time, and that particular time is referred to as a frame. The pressures can be sensed at a particular frequency, also referred to as a sampling frequency. This sampling frequency may be 800 times per second or 1000 times per second, although other sampling frequencies are contemplated.

The determination of whether a key is struck by the user in a particular frame may be based on a key press threshold amount. The key press threshold amount refers to a threshold amount of pressure that is to be applied to a key in order for the pressing of the key to be determined to be a key strike. This key press threshold amount may be 200 grams, although other threshold amounts are contemplated. If the pressure applied to the key does not rise to (e.g., is not equal to and/or greater than) the key press threshold amount, then the pressing of the key is determined to not be a key strike. However, if the pressure applied to the key does rise to (e.g., is equal to and/or greater than) the key press threshold amount, then the pressing of the key may be determined to be a key strike based on various other factors as discussed below.

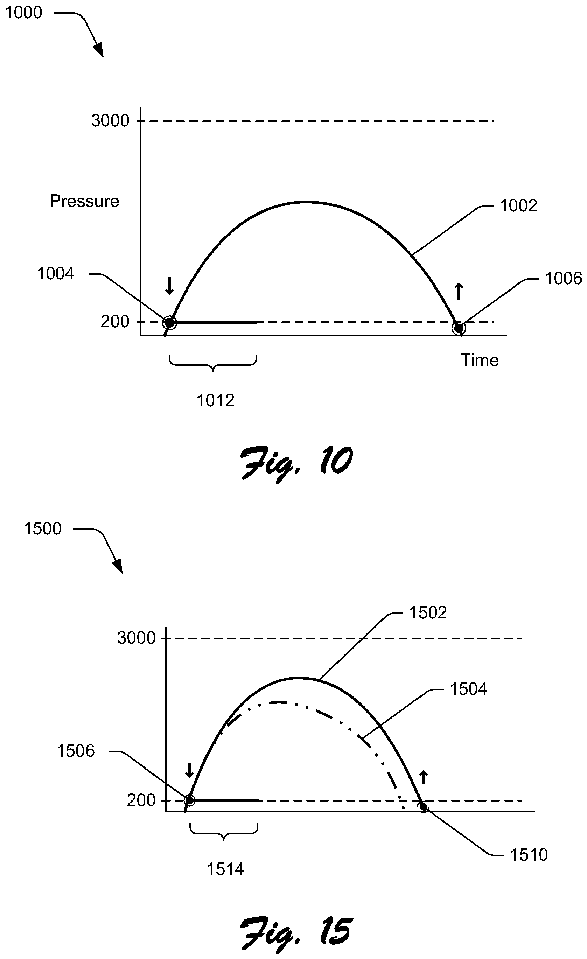

The determination of whether the key is struck can be performed in different manners. In some situations (e.g., situations in which the force concentrator layer techniques discussed above are used for a key), whether the key is struck is determined based on whether the pressure applied to the key rises to (e.g., is equal to and/or greater than) the key press threshold amount and optionally various other factors. These various other factors are discussed below with reference to FIGS. 10-18.

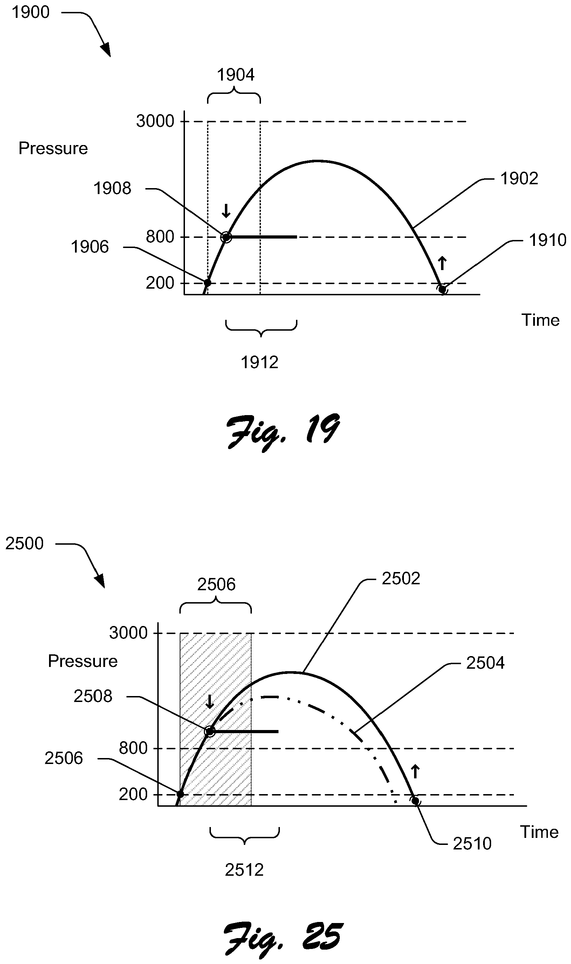

In other situations (e.g., situations in which the force concentrator layer techniques discussed above are not used for a key), whether the key is struck is determined based on the pressure applied to the key during a monitoring amount of time after the pressure applied to the key rises to (e.g., is equal to and/or greater than) the key press threshold amount. Whether the key is struck is also determined based on various other factors. This monitoring amount of time and these various other factors are discussed below (e.g., with reference to FIGS. 19-30).

Whether the pressure applied to a key rises to (e.g., is equal to and/or greater than) the key press threshold amount may be based on the pressure applied in a single frame. Alternatively, a hysteresis value may be used that indicates a number of frames for which the pressure applied to the key is to be evaluated to determine whether the pressure applied to the key rises to the key press threshold amount. This number of frames may be a number of consecutive frames (e.g., two frames, although other numbers of frames are contemplated), a particular ratio of frames (e.g., two out of five frames, although other ratios are contemplated), and so forth.

After a key is determined to have been struck, the key remains struck or pressed until the pressure applied to the key drops to (e.g., is less than and/or equal to) a key release threshold amount. This key release threshold amount may be 100 grams, although other threshold amounts are contemplated. The amount of time that the key is pressed is also referred to as a key press duration.

A de-bounce amount of time can optionally be implemented during which no key release is determined, even if the pressure on the key drops to the key release threshold amount. The de-bounce amount of time for a key begins when the key is determined to have been struck and continues for a particular duration. Alternatively, the de-bounce amount of time for a key can begin at other times, such as when the pressure applied to the key rises to (e.g., is greater than and/or equal to) another threshold value, such as 100 grams. This duration may be 40 ms, although other durations are contemplated. By implementing the de-bounce amount of time, false determinations of key releases due to bouncing or fluctuations in the keyboard (e.g., in the flexible contact layer 402 discussed above) may be avoided.

FIGS. 10-30 illustrate various example graphs of pressure applied to one or more keys over time. The vertical axis of each of these graphs is pressure (e.g., in grams) and the horizontal axis of each of these graphs is time (e.g., in milliseconds (ms)). Additionally, a down arrow is illustrated in the graphs above a point to indicate a key strike is determined to occur at that point, and an up arrow is illustrated in the graph above a point to indicate a key release is determined to occur at that point. For example, in FIG. 10, a down arrow is illustrated above point 1004 to indicate that the key is determined to be struck at point 1004, and an up arrow is illustrated above the point 1006 to indicate that the key is determined to be released at point 1006.

FIG. 10 depicts an example 1000 of a graph of pressure on one key over time illustrating a key strike. A line 1002 represents the pressure on the key over time. In response to the pressure on the key rising to the key press threshold amount (e.g., 200 grams) at point 1004, the key is determined as being struck at point 1004. The key remains pressed or struck until the pressure on the key drops to the key release threshold amount (e.g., 100 grams) at point 1006. A de-bounce amount of time 1012 (e.g., 40 ms) is also illustrated, beginning at the time the key is determined to be struck at point 1004.

One factor that may be used in determining whether a key is struck is how recently the key was determined to be released. A same key rejection time threshold is used to indicate the amount of time that a key is to be released prior to a determination subsequently being made that the key is struck. This same key rejection time threshold may be 60 ms, although other threshold values are contemplated. A same key rejection amount of time for a key begins when the key is determined to have been released and continues for the same key rejection time threshold. Alternatively, the same key rejection amount of time for a key can begin at other times, such as when the pressure applied to the key drops to (e.g., is less than and/or equal to) another threshold value, such as zero grams. During the same key rejection amount of time for a key, no key strike for that key is determined, even if the pressure applied to the key again rises to the key press threshold amount.

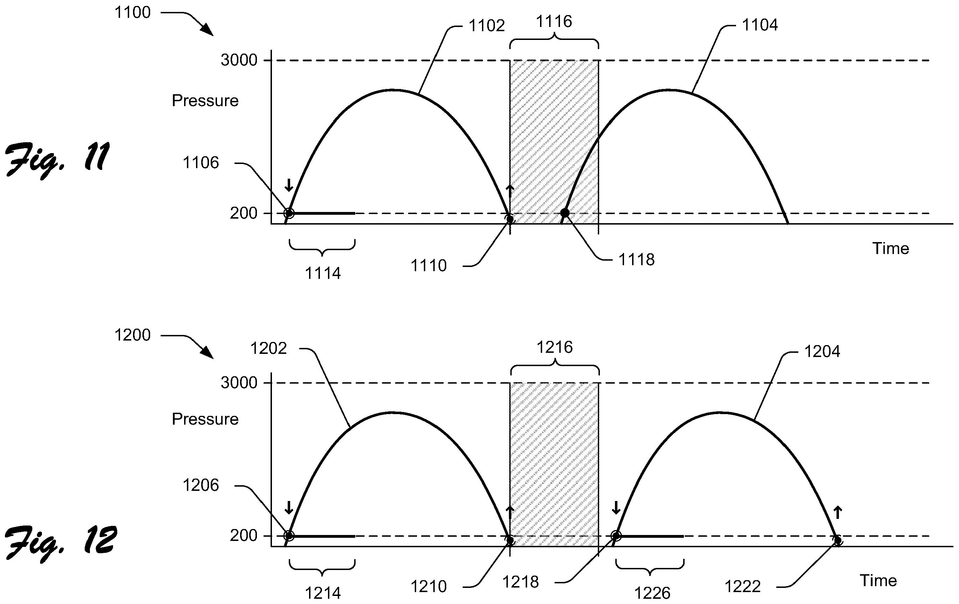

FIG. 11 depicts an example 1100 of a graph of pressure on one key over time illustrating an invalid key press due to a same key rejection amount of time not elapsing. A line 1102 represents the pressure on the key over a first time period, and a line 1104 represents the pressure on the key over a second time period. Lines 1102 and 1104 together indicate pressure applied to the key and released, and subsequently applied to the key again. In response to the pressure on the key rising to the key press threshold amount (e.g., 200 grams) at point 1106, the key is determined as being struck at point 1106. The key remains pressed or struck until the pressure on the key drops to the key release threshold amount (e.g., 100 grams) at point 1110. A de-bounce amount of time 1114 (e.g., 40 ms) is also illustrated, beginning at the time the key is determined to be struck at point 1106.

A same key rejection amount of time 1116 (e.g., 60 ms) is also illustrated, beginning at the time the key is determined to be released at point 1110. Even though the pressure on the key when the key is subsequently pressed rises to the key press threshold amount at point 1118, the key is not determined to be struck again because at the point 1118 the same key rejection amount of time has not yet elapsed. The pressure applied to the key is also referred to as an invalid key press. An invalid key press refers to pressure applied to a key being pressed (e.g., the pressure applied to the key rising to the key press threshold amount) but the key is not determined to be struck. Even though the key is not determined to be struck at point 1118, the key is not determined to be struck at a later time until after the pressure on the key has dropped to the key release threshold amount (and optionally until after the same key rejection amount of time elapses after the pressure on the key has dropped to the key release threshold amount).

FIG. 12 depicts an example 1200 of a graph of pressure on one key over time illustrating multiple key strikes of the same key. A line 1202 represents the pressure on the key over a first time period, and a line 1204 represents the pressure on the key over a second time period. Lines 1202 and 1204 together indicate pressure applied to the key and released, and subsequently applied to the key again. In response to the pressure on the key rising to the key press threshold amount (e.g., 200 grams) at point 1206, the key is determined as being struck at point 1206. The key remains pressed or struck until the pressure on the key drops to the key release threshold amount (e.g., 100 grams) at point 1210. A de-bounce amount of time 1214 (e.g., 40 ms) is also illustrated, beginning at the time the key is determined to be pressed at point 1206.

A same key rejection amount of time 1216 (e.g., 60 ms) is also illustrated, beginning at the time the key is determined to be released at point 1210. When the key is subsequently pressed, in response to the pressure on the key rising to the key press threshold amount at point 1218, the key is determined to be struck at point 1218 because the point 1218 is after the same key rejection amount of time 1216 has elapsed. The key remains pressed or struck until the pressure on the key drops to the key release threshold amount (e.g., 100 grams) at point 1222. A de-bounce amount of time 1226 (e.g., 40 ms) is also illustrated, beginning at the time the key is determined to be struck at point 1218.

Another factor that may be used in determining whether a key is struck is how recently a different key was determined to have been pressed. A different key rejection time threshold is used to indicate the amount of time that is to elapse after a key is pressed in order for a determination to be subsequently made that another key is struck. This different key rejection time threshold may be 40 ms, although other threshold values are contemplated. A different key rejection amount of time for a key begins when the key is determined to have been struck and continues for the different key rejection time threshold. Alternatively, the different key rejection amount of time for a key can begin at other times, such as when the pressure applied to the key rises to (e.g., is greater than and/or equal to) another threshold value, such as 100 grams, zero grams, and so forth. During the different key rejection amount of time for a key, no key strike for another key is determined, even if the pressure applied to the key again rises to the key press threshold amount.

This different key rejection amount of time optionally does not apply for certain types of keys, such as modifier keys. Modifier keys refer to keys that are intended to be struck with one or more other keys. Examples of modifier keys include an "alt" key, a "shift" key, a "control" key, a GUI (graphical user interface) or operating system key, and so forth. A different key rejection amount of time is optionally not used for modifier keys, and another key can thus optionally be determined as being struck within the different key rejection time threshold.

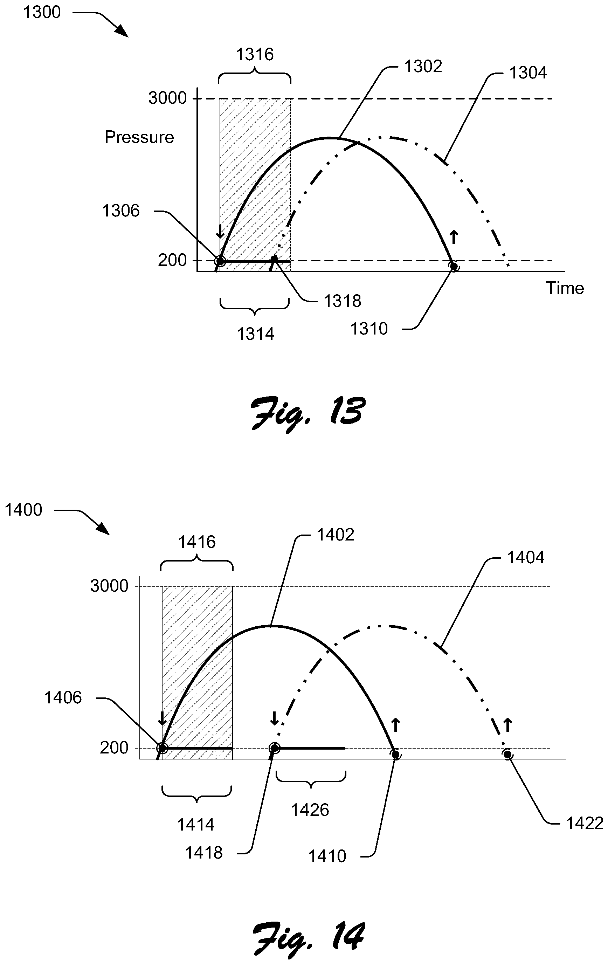

FIG. 13 depicts an example 1300 of a graph of pressure on multiple keys over time illustrating an invalid key press due to a different key rejection amount of time not elapsing. A line 1302 represents the pressure on a first key over a first time period, and a line 1304 represents the pressure on a second (different) key over a second time period. In response to the pressure on the first key rising to the key press threshold amount (e.g., 200 grams) at point 1306, the first key is determined as being struck at point 1306. The first key remains pressed or struck until the pressure on the first key drops to the key release threshold amount (e.g., 100 grams) at point 1310. A de-bounce amount of time 1314 (e.g., 40 ms) is also illustrated, beginning at the time the first key is determined to be struck, at point 1306.

A different key rejection amount of time 1316 (e.g., 40 ms) is also illustrated, beginning at the time the first key is determined to be struck at point 1306. Even though the pressure on the second key when the second key is subsequently pressed rises to the key press threshold amount at point 1318, the second key is not determined to be struck again because at the point 1318 the different key rejection amount of time has not yet elapsed. Even though the second key is not determined to be struck at point 1318, the second key is not determined to be struck at a later time until after the pressure on the second key has dropped to the key release threshold amount (and optionally until after the same key rejection amount of time elapses after the pressure on the second key has dropped to the key release threshold amount as discussed above).

FIG. 14 depicts an example 1400 of a graph of pressure on multiple keys over time illustrating multiple key strikes of different keys. A line 1402 represents the pressure on a first key over a first time period, and a line 1404 represents the pressure on a second (different) key over a second time period. In response to the pressure on the first key rising to the key press threshold amount (e.g., 200 grams) at point 1406, the first key is determined as being struck at point 1406. The first key remains pressed or struck until the pressure on the first key drops to the key release threshold amount (e.g., 100 grams) at point 1410. A de-bounce amount of time 1414 (e.g., 40 ms) is also illustrated, beginning at the time the first key is determined to be struck, at point 1406.

A different key rejection amount of time 1416 (e.g., 40 ms) is also illustrated, beginning at the time the first key is determined to be struck at point 1406. When the second key is subsequently pressed, in response to the pressure on the second key rising to the key press threshold amount at point 1418, the second key is determined to be struck at point 1418 because the point 1418 is after the different key rejection amount of time 1416 has elapsed. The second key remains pressed or struck until the pressure on the second key drops to the key release threshold amount (e.g., 100 grams) at point 1422. A de-bounce amount of time 1426 (e.g., 40 ms) is also illustrated, beginning at the time the second key is determined to be struck at point 1418.

Another factor that may be used in determining whether a key is struck is whether another key is pressed at approximately the same time. In situations in which two or more keys are pressed in the same frame or alternatively within a few frames of one another (e.g., within a threshold number of frames, such as one frame although other threshold numbers are contemplated), the key to which the greater pressure is applied is determined to be the key that is struck. Two or more keys are pressed in the same frame (or alternatively within a threshold number of frames) if the pressure applied to each of the two or more keys rises to (e.g., is equal to and/or greater than) the key press threshold amount in the frame. This determination of the greater pressure can be made based on the pressure applied in the frame in which the two or more keys rise to the key press threshold amount. Alternatively, this determination can be based on different time durations, such as the pressure over the lifetime of the key strikes (the lifetime of a key strike beginning when the pressure applied to the key rises to the key press threshold amount and ending when the pressure applied to the key drops to the key release threshold amount), some threshold amount of time (e.g., 30 ms or 40 ms, although other threshold amounts of time are contemplated) after the pressures applied to the keys rise to the key press threshold amount, and so forth.

FIG. 15 depicts an example 1500 of a graph of pressure on multiple keys over time illustrating multiple keys pressed at approximately the same time. A line 1502 represents the pressure on a first key over a first time period, and a line 1504 represents the pressure on a second (different) key over a second time period. The pressure applied to each of the two keys rises to the key press threshold amount (e.g., 200 grams) in the same frame (or within a few frames of one another), at point 1506. The key that is determined to be the key that is struck is the key to which the greater pressure is applied, which is the first key in the example 1500 (illustrated by the line 1502). The first key remains pressed or struck until the pressure on the key drops to the key release threshold amount (e.g., 100 grams) at point 1510. A de-bounce amount of time 1514 (e.g., 40 ms) is also illustrated, beginning at the time the key is determined to be struck, at point 1506.

The second key (illustrated by the line 1504) is not determined to be struck. Even though the pressure on the second key rises to the key press threshold amount at point 1506, the key is not determined to be struck because the pressure applied to the first key was greater. Even though the second key is not determined to be struck at point 1506, the key is not determined to be struck at a later time until after the pressure on the second key has dropped to the key release threshold amount (and optionally until after the same key rejection amount of time elapses after the pressure on the second key has dropped to the key release threshold amount as discussed above).

Another factor that may be used in determining whether a key is struck is how many other keys have been pressed (e.g., key strikes or invalid key presses) and are still pressed. A key press count threshold is used to indicate how many keys can be pressed concurrently. This key press count threshold may be 3 or 4, although other threshold values are contemplated. The key press count threshold may vary based on whether one of the keys is a modifier key (e.g., an "alt" key, a "shift" key, a "control" key, a GUI (graphical user interface) or operating system key, and so forth). For example, the key press count threshold may be 3 if none of the keys is a modifier, or may be 4 if one of the keys (any one of the keys, or optionally just the first) is a modifier key. By way of another example, the key press count may be larger (e.g., 10 or 12) in some situations (e.g., for a gaming keyboard). The key press count may also not be used as a factor in determining whether a key is struck in some situations (e.g., for a gaming keyboard).

If the number of keys pressed concurrently reaches (e.g., is equal to and/or greater than) the key press count threshold, then no more keys are determined to be struck until the pressure applied to the keys drops to (e.g., is less than and/or equal to) the key release threshold amount. No more keys may be determined to be struck until the pressure applied to all of the keys on the keyboard drops to the key release threshold amount, or alternatively until the pressure applied to a subset of the keys on the keyboard (e.g., the keys that were pressed that caused the number of keys pressed concurrently to reach the key press count threshold) drops to the key release threshold amount.

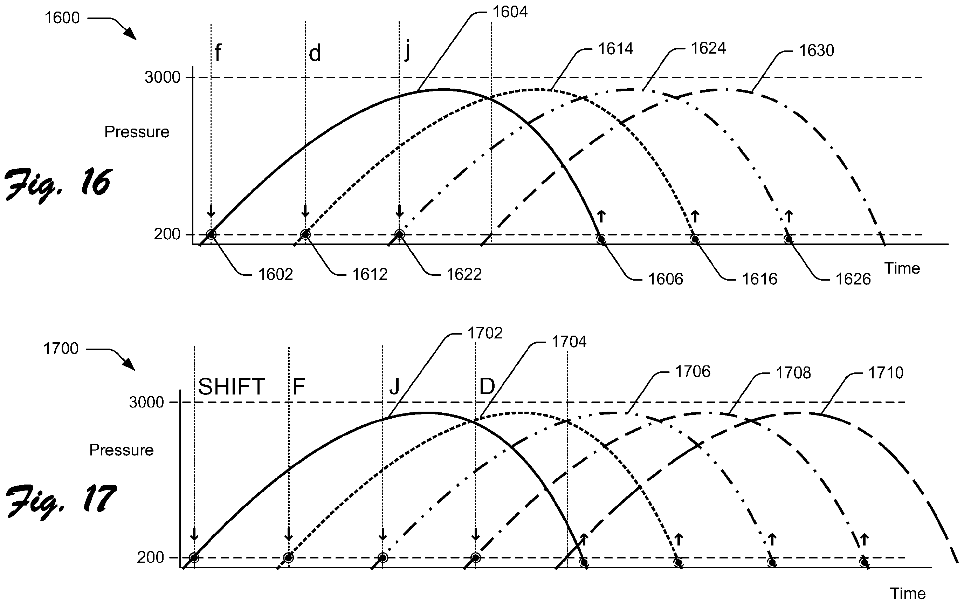

FIG. 16 depicts an example 1600 of a graph of pressure on multiple keys concurrently over time illustrating multiple key strikes resulting from concurrently pressed keys. In response to the pressure applied to a first key, illustrated as the key corresponding to the letter "f', rising to the key press threshold amount (e.g., 200 grams) at point 1602, the first key is determined as being struck at point 1602. Line 1604 represents the pressure applied on the first key over a first period of time. The first key remains pressed or struck until the pressure on the first key drops to the key release threshold amount (e.g., 100 grams) at point 1606.

Pressure is applied to a second key, illustrated as the key corresponding to the letter "d", concurrently with pressure being applied to the first key. In response to the pressure applied to the second key rising, after the different key rejection amount of time due to the first key being struck has elapsed, to the key press threshold amount (e.g., 200 grams) at point 1612, the second key is determined as being struck at point 1612. Line 1614 represents the pressure applied on the second key over a second period of time. The second key remains pressed or struck until the pressure on the second key drops to the key release threshold amount (e.g., 100 grams) at point 1616.

Pressure is also applied to a third key, illustrated as the key corresponding to the letter "j", concurrently with pressure being applied to the first key and the second key. In response to the pressure applied to the third key rising, after the different key rejection amount of time due to the second key being struck has elapsed, to the key press threshold amount (e.g., 200 grams) at point 1622, the third key is determined as being struck at point 1622. Line 1624 represents the pressure applied on the third key over a third period of time. The third key remains pressed or struck until the pressure on the third key drops to the key release threshold amount (e.g., 100 grams) at point 1626.

Pressure is also applied to a fourth key concurrently with pressure being applied to the first, second, and third keys. Line 1630 represents the pressure applied on the fourth key over a fourth period of time. Even though the pressure on the fourth key rises to the key press threshold amount, the fourth key is not determined to be struck because the number of keys pressed concurrently has reached the key press count when the fourth key is pressed. Thus, no more keys are determined to be struck until the pressure applied to the keys drops to the key release threshold amount. The key strikes for the keys corresponding to the letters "f', "d", and "j" may still be maintained as key strikes, but no more keys are determined to be struck until the pressure applied to the keys drops to the key release threshold amount. Alternatively, in response to the number of keys pressed concurrently reaching the key press count threshold, the previously determined key strikes for the keys corresponding to the letters "f', "d", and "j" may be deleted or ignored, so that those key strikes are no longer determined to be key strikes.

FIG. 17 depicts an example 1700 of a graph of pressure on multiple keys concurrently over time illustrating multiple key strikes resulting from concurrently pressed keys. Example 1700 is similar to example 1600 of FIG. 16, but includes a modifier key as well. Line 1702 represents the pressure applied on a first key (illustrated as the key corresponding to the "shift" modifier key), line 1704 represents the pressure applied on a second key (illustrated as the key corresponding to the letter "F"), line 1706 represents the pressure applied on a third key (illustrated as the key corresponding to the letter "J"), line 1708 represents the pressure applied on a fourth key (illustrated as the key corresponding to the letter "D"), and line 1710 represents the pressure applied on a fifth key.

Even though the pressure on the fifth key rises to the key press threshold amount, the fifth key is not determined to be struck because the number of keys pressed concurrently has reached the key press count threshold when the fifth key is pressed. The key press count threshold is one higher in the example 1700 than in the example 1600 of FIG. 16 because one of the keys in the example 1700 is a modifier key. No more keys are determined to be struck until the pressure applied to the keys drops to the key release threshold amount. The key strikes for the keys corresponding to the letters "F", "D", and "J" may still be maintained as key strikes, but no more keys are determined to be struck until the pressure applied to the keys drops to the key release threshold amount. Alternatively, in response to the number of keys pressed concurrently reaching the key press count threshold, the previously determined key strikes for the keys corresponding to the letters "F", "D", and "J" may be deleted or ignored, so that those key strikes are no longer determined to be key strikes.

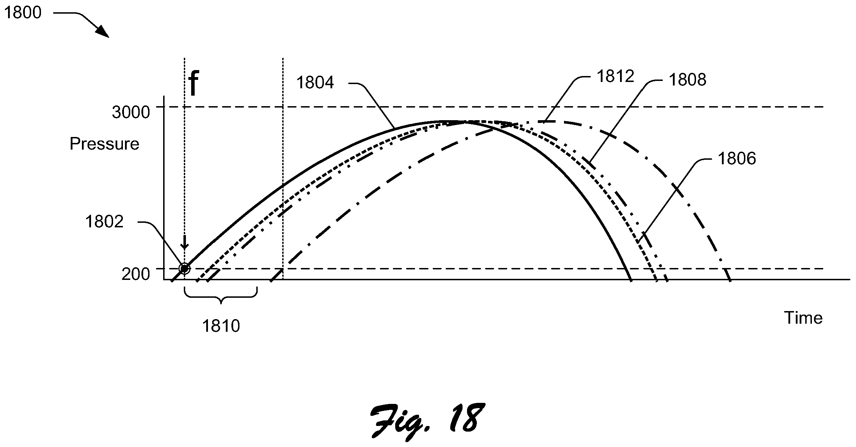

FIG. 18 depicts an example 1800 of a graph of pressure on multiple keys concurrently over time illustrating invalid key presses resulting from concurrently pressed keys. In response to the pressure applied to a first key, illustrated as the key corresponding to the letter "f', rising to the key press threshold amount (e.g., 200 grams) at point 1802, the first key is determined as being struck at point 1802. Line 1804 represents the pressure applied on the first key over a first period of time. The first key remains pressed or struck until the pressure on the first key drops to the key release threshold amount (e.g., 100 grams)

Pressure is also applied to a second key concurrently with pressure being applied to the first key. Line 1806 represents the pressure applied on the second key over a second period of time. Pressure is also applied to a third key concurrently with pressure being applied to the first and second keys. Line 1808 represents the pressure applied on the third key over a third period of time. A different key rejection amount of time 1810 (e.g., 40 ms is also illustrated, beginning at the time the first key is determined to be struck at point 1802). Even though the pressures applied on the second and third keys rise to the key press threshold amount, the second and third keys are not determined to be struck because the different key rejection amount of time has not elapsed at the points where the pressures applied on the second and third keys rise to the key press threshold amount.

Furthermore, pressure is also applied to a fourth key concurrently with pressure being applied to the first, second, and third keys. Line 1812 represents the pressure applied on the fourth key over a fourth period of time. A record is maintained that the pressures applied to the second and third keys rose to the key press threshold amount even though the pressures applied were not determined to be key strikes. Thus, the second and third keys are included in the key press count. Therefore, even though the pressure on the fourth key rises to the key press threshold amount after the different key rejection amount of time 1810 elapses, the fourth key is not determined to be struck because the number of keys pressed concurrently has reached the key press count when the fourth key is pressed. Thus, no more keys are determined to be struck until the pressure applied to the keys drops to the key release threshold amount. The key strike for the key corresponding to the letter "f' may still be maintained as a key strike, but no more keys are determined to be struck until the pressure applied to the keys drops to the key release threshold amount. Alternatively, in response to the number of keys pressed concurrently reaching the key press count threshold, the previously determined key strike for the key corresponding to the letter "f' may be deleted or ignored, so that that key strike is no longer determined to be a key strike.

FIGS. 10-18 discuss situations where the determination of whether the key is struck is based on whether the pressure applied to the key rises to the key press threshold amount. In other situations (e.g., discussed with reference to FIGS. 19-28) whether the key is struck is determined based on the pressure applied to the key during a monitoring amount of time after the pressure applied to the key rises to the key press threshold amount.

The monitoring amount of time is a time duration or time period, also referred to as an indeterminate range, in which it is not yet determined whether the key was struck (e.g., the pressure may be the result of a light key strike or an inadvertent touching of the key). During the monitoring amount of time, the pressure applied to the key is analyzed and a determination is made as to whether the pressure applied to the key is a key strike. The monitoring amount of time for a key begins when the pressure applied to the key rises to (e.g., is equal to and/or greater than) the key press threshold amount (e.g., 200 grams, as discussed above). The monitoring amount of time may be 30 ms, although other amounts of time are contemplated.

The key may be determined as being struck in response to the pressure applied to the key rising to (e.g., being equal to and/or greater than) a selection threshold amount during the monitoring period. If the pressure applied to the key does not rise to the selection threshold amount during the monitoring period, then the key is determined not to have been struck. This selection threshold amount may be 800 grams, although other selection threshold amounts are contemplated. The key may alternatively be determined as being struck in response to a slope of a line graphing the pressure applied to the key over time rising to (e.g., being equal to and/or greater than) a threshold slope during the monitoring period. This threshold slope is also referred to as a threshold rate at which the pressure is applied to the key. If the slope of the line graphing pressure over time does not rise to the threshold slope during the monitoring period, then the key is determined to not have been struck. This threshold slope may be 20 grams/millisecond, although other threshold slopes are contemplated. After a key is determined to have been struck, the key remains struck or pressed until the pressure applied to the key drops to (e.g., is less than and/or equal to) the key release threshold amount, as discussed above.

It should be noted that situations can arise in which the pressure applied to the key rises to the selection threshold amount in the same frame in which the pressure applied to the key rises to the key press threshold amount. For example, the pressure on a key may rise from zero grams to 900 grams in a single frame. In such situations, the monitoring period need not be used because the pressure has already risen to the selection threshold amount. Alternatively, the monitoring period may still be used in such situations.

Whether the pressure applied to a key rises to (e.g., is equal to and/or greater than) the key press threshold amount and/or selection threshold amount may be based on the pressure applied in a single frame. Alternatively, a hysteresis value may be used that indicates a number of frames for which the pressure applied to the key is to be evaluated to determine whether the pressure applied to the key rises to the key press threshold amount and/or selection threshold amount. As discussed above, this number of frames may be a number of consecutive frames, a particular ratio of frames, and so forth.

A de-bounce amount of time can optionally be implemented during which no key release is determined, even if the pressure on the key drops to the key release threshold amount as discussed above. The de-bounce amount of time for a key begins when the key is determined to have been struck and continues for a particular duration as discussed above.

FIG. 19 depicts an example 1900 of a graph of pressure on one key over time illustrating a key strike. A line 1902 represents the pressure on the key over time. A monitoring period (e.g., 30 ms) 1904 is illustrated, which starts in response to the pressure on the key rising to the key press threshold amount (e.g., 200 grams) at point 1906. In response to the pressure on the key rising to the selection threshold amount (e.g., 800 grams) and/or the slope of the line 1902 rising to a threshold slope (e.g., 20 grams/millisecond) during the monitoring period at point 1908, the key is determined as being struck at point 1908.

The key remains pressed or struck until the pressure on the key drops to the key release threshold amount (e.g., 100 grams) at point 1910. A de-bounce amount of time 1912 (e.g., 40 ms) is also illustrated, beginning at the time the key is determined to be pressed at point 1908.

The graph 1900 is similar to the graph 1000 of FIG. 10, although different techniques are used to determine whether the key is struck. In the graph 1000, the key is determined to be struck in response to the pressure applied to the key rising to the key press threshold amount, whereas in the graph 1900 the key is determined to be struck in response to the pressure on the key rising to the selection threshold amount and/or the slope of the line rising to the threshold slope during the monitoring period.

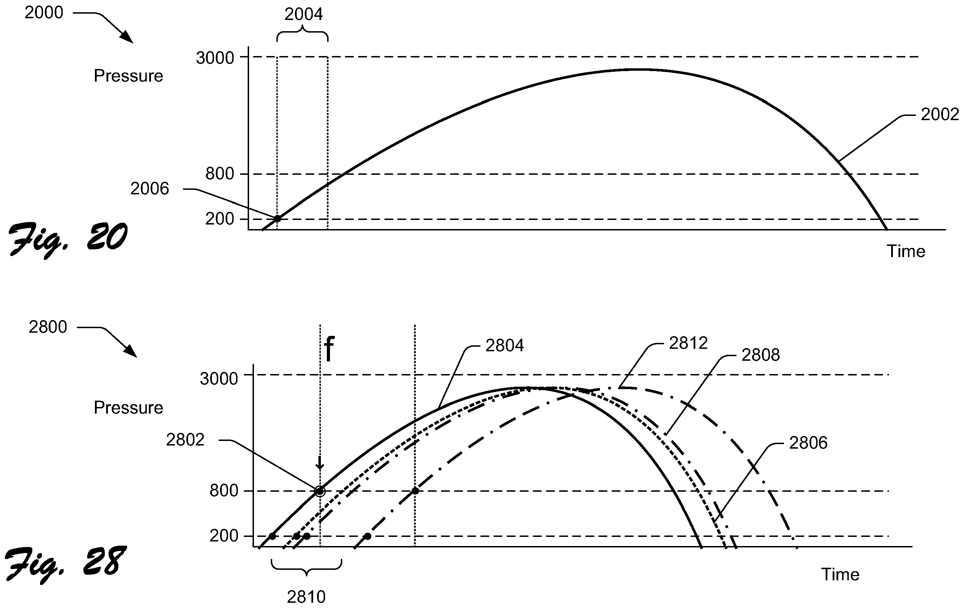

FIG. 20 depicts an example 2000 of a graph of pressure on one key over time illustrating an invalid key press. A line 2002 represents the pressure on the key over time. A monitoring period (e.g., 30 ms) 2004 is illustrated on the graph, which starts in response to the pressure on the key rising to the key press threshold amount (e.g., 200 grams) at point 2006. However, because the slope of the line 2002 does not rise to the threshold slope during the monitoring period 2004 and the pressure on the key does not rise to the selection threshold amount (e.g., 800 grams) during the monitoring period 2004, the key is not determined as being struck. Thus, even though the pressure on the key rises to the selection threshold amount, the key is not determined as being struck because the pressure on the key did not rise to the selection threshold amount during the monitoring period 2004.

In response to the pressure on a key rising to the key press threshold amount (e.g., 200 grams), the key is determined to be not released (although not necessarily struck yet, as discussed above). The key is subsequently determined to be released in response to the pressure on the key dropping to (e.g., being equal to and/or less than) the release threshold amount. Thus, even though the key is not determined to be struck in the example of FIG. 20, the key is not determined to be struck at a later time until after the pressure on the key has dropped to the key release threshold amount (and optionally until after the same key rejection amount of time elapses after the pressure on the key has dropped to the key release threshold amount).

As discussed above, a factor that may be used in determining whether a key is struck is how recently the key was determined to be released. A same key rejection amount of time for a key begins when the key is determined to have been released and continues for the same key rejection time threshold. Alternatively, the same key rejection amount of time for a key can begin at other times, such as when the pressure applied to the key drops to (e.g., is less than and/or equal to) another threshold value, such as zero grams. During the same key rejection amount of time for a key, no key strike for that key is determined and no monitoring period for that key begins again. Alternatively, the monitoring period for that key may begin again during the different key rejection amount of time, but no key strike may be determined unless the pressure applied to the key rises to the selection threshold amount after the same key rejection amount of time elapses.

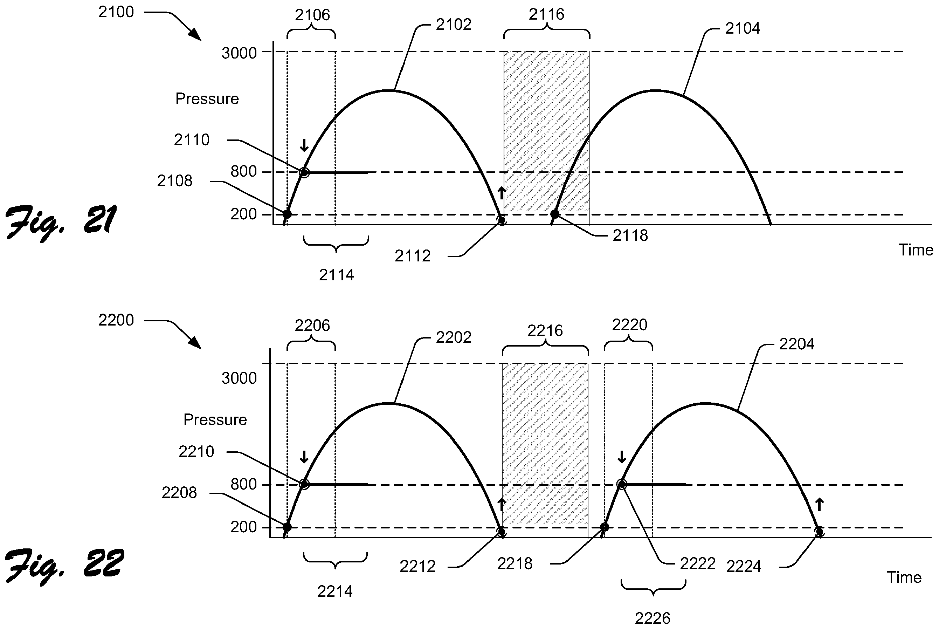

FIG. 21 depicts an example 2100 of a graph of pressure on one key over time illustrating an invalid key press due to a same key rejection amount of time not elapsing. A line 2102 represents the pressure on the key over a first time period, and a line 2104 represents the pressure on the key over a second time period. Lines 2102 and 2104 together indicate pressure applied to the key and released, and subsequently applied to the key again. A monitoring period (e.g., 30 ms) 2106 is illustrated, which starts in response to the pressure on the key rising to the key press threshold amount (e.g., 200 grams) at point 2108. In response to the pressure on the key rising to the selection threshold amount (e.g., 800 grams) and/or the slope of the line 2102 rising to a threshold slope (e.g., 20 grams/millisecond) during the monitoring period at point 2110, the key is determined as being struck at point 2110. The key remains pressed or struck until the pressure on the key drops to the key release threshold amount (e.g., 100 grams) at point 2112. A de-bounce amount of time 2114 (e.g., 40 ms) is also illustrated, beginning at the time the key is determined to be struck at point 2110.

A same key rejection amount of time 2116 (e.g., 60 ms) is also illustrated, beginning at the time the key is determined to be released at point 2112. Even though the pressure on the key when the key is subsequently pressed rises to the key press threshold amount at point 2118, the key is not determined to be struck again because at the point 2118 the same key rejection amount of time has not yet elapsed. No monitoring period need be used in response to the pressure on the key rising to the key press threshold amount at point 2118 because the same key rejection amount of time has not yet elapsed. Additionally, even though the key is not determined to be struck at point 2118, the key is not determined to be struck at a later time until after the pressure on the key has dropped to the key release threshold amount (and optionally until after the same key rejection amount of time elapses after the pressure on the key has dropped to the key release threshold amount).

FIG. 22 depicts an example 2200 of a graph of pressure on one key over time illustrating multiple key strikes of the same key. A line 2202 represents the pressure on the key over a first time period, and a line 2204 represents the pressure on the key over a second time period. Lines 2202 and 2204 together indicate pressure applied to the key and released, and subsequently applied to the key again. A monitoring period (e.g., 30 ms) 2206 is illustrated, which starts in response to the pressure on the key rising to the key press threshold amount (e.g., 200 grams) at point 2208. In response to the pressure on the key rising to the selection threshold amount (e.g., 800 grams) and/or the slope of the line 2202 rising to a threshold slope (e.g., 20 grams/millisecond) during the monitoring period at point 2210, the key is determined as being struck at point 2210. The key remains pressed or struck until the pressure on the key drops to the key release threshold amount (e.g., 100 grams) at point 2212. A de-bounce amount of time 2214 (e.g., 40 ms) is also illustrated, beginning at the time the key is determined to be pressed at point 2210.

A same key rejection amount of time 2216 (e.g., 60 ms) is also illustrated, beginning at the time the key is determined to be released at point 2212. When the key is subsequently pressed, in response to the pressure on the key rising to the key press threshold amount (e.g., 200 grams) at point 2218, a monitoring period (e.g., 30 ms) 2220 starts. In response to the pressure on the key rising to the selection threshold amount (e.g., 800 grams) and/or the slope of the line 2204 rising to a threshold slope (e.g., 20 grams/millisecond) during the monitoring period at point 2220, the key is determined as being struck at point 2222 because the point 2218 is after the same key rejection amount of time 2216 has elapsed. The key remains pressed or struck until the pressure on the key drops to the key release threshold amount (e.g., 100 grams) at point 2224. A de-bounce amount of time 2226 (e.g., 40 ms) is also illustrated, beginning at the time the key is determined to be struck at point 2222.

As discussed above, a factor that may be used in determining whether a key is struck is how recently a different key was determined to have been pressed. A different key rejection amount of time for a key begins when the pressure applied to the key rises to the key press threshold amount (e.g., 200 grams). Alternatively, the different key rejection amount of time may begin at other times, such as at the time the key is determined to be struck or at some other time between the time the pressure on the key rises to the key press threshold amount and the time the key is determined to be struck, when the pressure applied to the key rises to (e.g., is greater than and/or equal to) another threshold value, such as 100 grams, zero grams, and so forth. During the different key rejection amount of time for a key, no key strike for another key is determined and no monitoring period for another key begins. Alternatively, the monitoring period for another key may begin during the different key rejection amount of time, but no key strike may be determined unless the pressure applied to the key rises to the selection threshold amount after the different key rejection amount of time elapses.

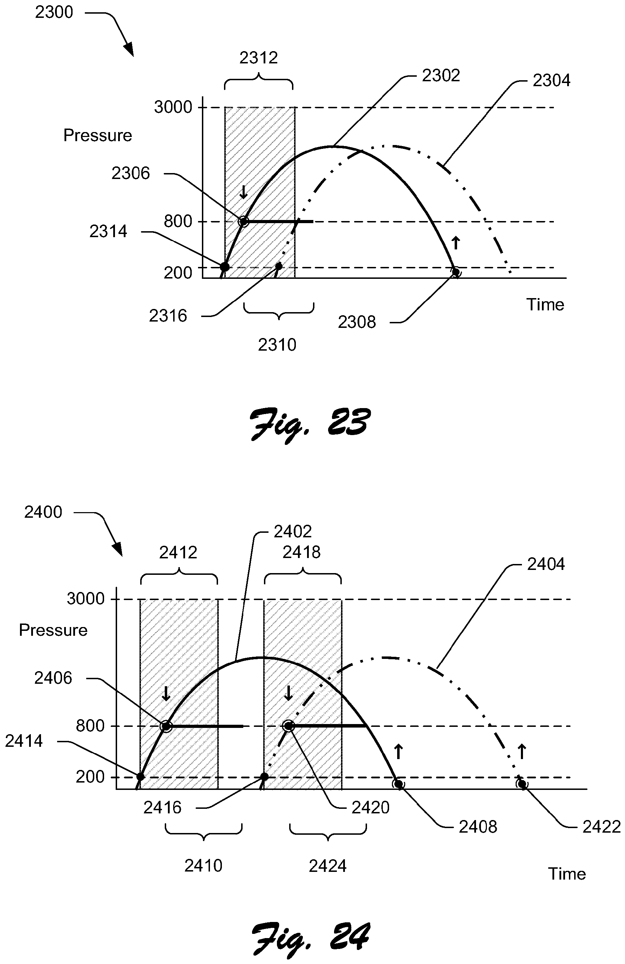

FIG. 23 depicts an example 2300 of a graph of pressure on multiple keys over time illustrating an invalid key press due to a different key rejection amount of time not elapsing. A line 2302 represents the pressure on a first key over a first time period, and a line 2304 represents the pressure on a second (different) key over a second time period. In response to the pressure on the first key rising to the selection threshold amount (e.g., 800 grams) and/or the slope of the line 2302 rising to a threshold slope (e.g., 20 grams/millisecond) during a monitoring period (not shown) at point 2306, the key is determined as being struck at point 2306. The first key remains pressed or struck until the pressure on the first key drops to the key release threshold amount (e.g., 100 grams) at point 2308. A de-bounce amount of time 2310 (e.g., 40 ms) is also illustrated, beginning at the time the first key is determined to be struck, at point 2306.

A different key rejection amount of time 2312 (e.g., 40 ms) is also illustrated, beginning at the time the pressure on the key rises to the key press threshold amount (e.g., 200 grams) at point 2314. Even though the pressure on the second key when the second key is subsequently pressed rises to the key press threshold amount at point 2316, the second key is not determined to be struck because at the point 2316 the different key rejection amount of time has not yet elapsed. No monitoring period need be used in response to the pressure on the second key rising to the key press threshold amount at point 2316 because the different key rejection amount of time has not yet elapsed. Additionally, even though the second key is not determined to be struck at point 2316, the second key is not determined to be struck at a later time until after the pressure on the second key has dropped to the key release threshold amount (and optionally until after the same key rejection amount of time elapses after the pressure on the second key has dropped to the key release threshold amount as discussed above).

FIG. 24 depicts an example 2400 of a graph of pressure on multiple keys over time illustrating multiple key strikes of different keys. A line 2402 represents the pressure on a first key over a first time period, and a line 2404 represents the pressure on a second (different) key over a second time period. In response to the pressure on the first key rising to the selection threshold amount (e.g., 800 grams) and/or the slope of the line 2402 rising to a threshold slope (e.g., 20 grams/millisecond) during a monitoring period (not shown) at point 2406, the key is determined as being struck at point 2406. The first key remains pressed or struck until the pressure on the first key drops to the key release threshold amount (e.g., 100 grams) at point 2408. A de-bounce amount of time 2410 (e.g., 40 ms) is also illustrated, beginning at the time the first key is determined to be struck, at point 2406.

A different key rejection amount of time 2412 (e.g., 40 ms) is also illustrated, beginning at the time the pressure on the key rises to the key press threshold amount (e.g., 200 grams) at point 2414. When the second key is subsequently pressed, in response to the pressure on the key rising to the key press threshold amount (e.g., 200 grams) at point 2416, a monitoring period (e.g., 30 ms) 2418 starts. In response to the pressure on the key rising to the selection threshold amount (e.g., 800 grams) and/or the slope of the line 2404 rising to a threshold slope (e.g., 20 grams/millisecond) during the monitoring period at point 2420, the key is determined as being struck at point 2420 because the point 2416 is after the different key rejection amount of time 2412 has elapsed. The second key remains pressed or struck until the pressure on the second key drops to the key release threshold amount (e.g., 100 grams) at point 2422. A de-bounce amount of time 2424 (e.g., 40 ms) is also illustrated, beginning at the time the second key is determined to be struck at point 2420.

Another factor that may be used in determining whether a key is struck is whether another key is pressed at approximately the same time, as discussed above. In situations in which two or more keys are pressed in the same frame (or within a few frames of one another), the key to which the greater pressure is applied is determined to be the key that is struck. Two or more keys are pressed in the same frame (or alternatively within a threshold number of frames) if, for example, the pressure applied to each of the two or more keys rises to (e.g., is equal to and/or greater than) the key press threshold amount in the frame and the pressure on each of the keys rises to the selection threshold amount (e.g., 800 grams) and/or the slope of the lines graphing pressure for the keys rises to a threshold slope (e.g., 20 grams/millisecond) during the monitoring period. This determination of the greater pressure can be made based on the pressure applied in the frame in which the two or more keys rise to the key press threshold amount. Alternatively, this determination of the greater pressure can be based on different time durations, such as the pressure over the lifetime of the key strikes, the pressure applied during the monitoring period, some threshold amount of time (e.g., 30 ms or 40 ms, although other threshold amounts of time are contemplated) after the pressures applied to the keys rise to the key press threshold amount, and so forth.

FIG. 25 depicts an example 2500 of a graph of pressure on multiple keys over time illustrating multiple keys pressed at approximately the same time. A line 2502 represents the pressure on a first key over a first time period, and a line 2504 represents the pressure on a second (different) key over a second time period. A monitoring period (e.g., 30 ms) 2506 is illustrated for both keys, which starts in response to the pressure on each key rising to the key press threshold amount (e.g., 200 grams) in the same frame (or within a few frames of one another), at point 2506. Different monitoring periods are typically maintained and analyzed for each key, although a single monitoring period is illustrated due to the monitoring periods for the two keys beginning at the same frame (or within a few frames of one another). The pressure on each of the keys rises to the selection threshold amount (e.g., 800 grams) and/or the slope of the line 2502 and/or 2504 rises to a threshold slope (e.g., 20 grams/millisecond) during the monitoring period, illustrated as occurring at point 2508. The key that is determined to be the key that is struck is the key to which the greater pressure is applied, which is the first key in the example 2500 (illustrated by the line 2502). The first key remains pressed or struck until the pressure on the key drops to the key release threshold amount (e.g., 100 grams) at point 2510. A de-bounce amount of time 2512 (e.g., 40 ms) is also illustrated, beginning at the time the key is determined to be struck, at point 2508.

The second key (illustrated by the line 2504) is not determined to be struck. Even though the pressure on the second key rises to the selection threshold amount at point 2508, the key is not determined to be struck because the pressure applied to the first key was greater. Even though the second key is not determined to be struck at point 2508, the key is not determined to be struck at a later time until after the pressure on the second key has dropped to the key release threshold amount (and optionally until after the same key rejection amount of time elapses after the pressure on the second key has dropped to the key release threshold amount as discussed above).

Another factor that may be used in determining whether a key is struck is how many other keys have been pressed and are still pressed, as discussed above. A key press count threshold is used to indicate how many keys can be pressed concurrently (e.g., 3 or 4, 10 or 12, etc. although other threshold values are contemplated), as discussed above. The key press count may also not be used as a factor in determining whether a key is struck in some situations, as discussed above.

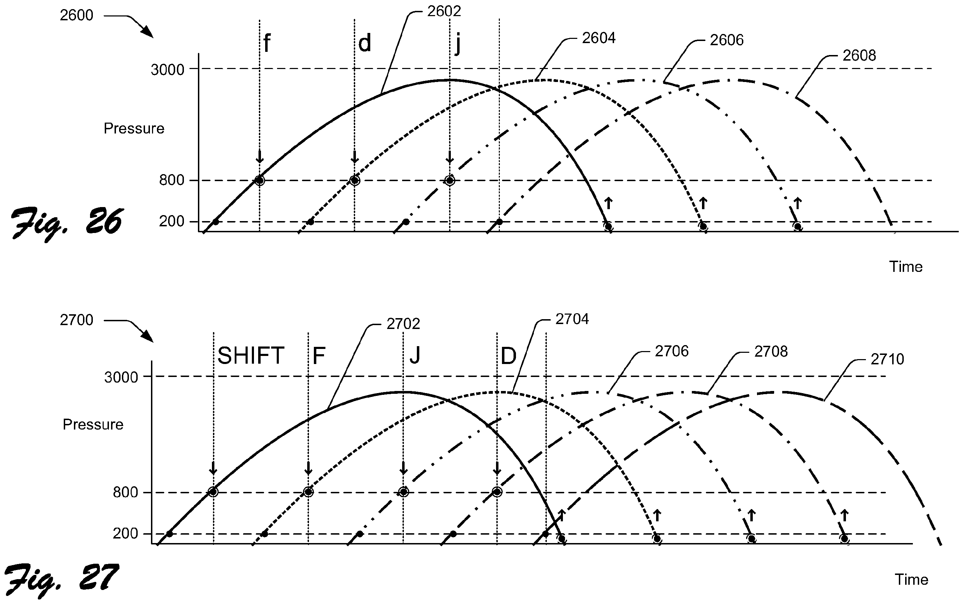

FIG. 26 depicts an example 2600 of a graph of pressure on multiple keys concurrently over time illustrating multiple key strikes resulting from concurrently pressed keys. Example 2600 is similar to the example 1600 of FIG. 16, except that each key is determined to be struck in response the pressure on the key rising to the selection threshold amount (e.g., 800 grams) and/or the slope of the line graphing the pressure of the key over time rising to a threshold slope (e.g., 20 grams/millisecond) during a monitoring period (not shown), rather than the pressure applied to the key simply rising to the key press threshold amount.

Line 2602 represents the pressure applied on a first key (illustrated as the key corresponding to the letter "f'), line 2604 represents the pressure applied on a second key (illustrated as the key corresponding to the letter "d"), and line 2606 represents the pressure applied on a third key (illustrated as the key corresponding to the letter "j"), and line 2608 represents the pressure applied on a fourth key. Even though the pressure on the fourth key rises to the selection threshold amount (e.g., 800 grams) and/or the slope of the line 2608 rises to a threshold slope (e.g., 20 grams/millisecond) during a monitoring period, the fourth key is not determined to be struck because the number of keys pressed concurrently has reached the key press count when the fourth key is pressed. Thus, no more keys are determined to be struck until the pressure applied to the keys drops to the key release threshold amount. The key strikes for the keys corresponding to the letters "f', "d", and "j" may still be maintained as key strikes, but no more keys are determined to be struck until the pressure applied to the keys drops to the key release threshold amount. Alternatively, in response to the number of keys pressed concurrently reaching the key press count threshold, the previously determined key strikes for the keys corresponding to the letters "f", "d", and "j" may be deleted or ignored, so that those key strikes are no longer determined to be key strikes.

FIG. 27 depicts an example 2700 of a graph of pressure on multiple keys concurrently over time illustrating multiple key strikes resulting from concurrently pressed keys. Example 2600 is similar to the example 1700 of FIG. 17, except that each key is determined to be struck in response the pressure on the key rising to the selection threshold amount (e.g., 800 grams) and/or the slope of the line graphing the pressure of the key over time rising to a threshold slope (e.g., 20 grams/millisecond) during a monitoring period (not shown), rather than the pressure applied to the key simply rising to the key press threshold amount. Example 2700 also includes a modifier key as well.

Line 2702 represents the pressure applied on a first key (illustrated as the key corresponding to the "shift" modifier key), line 2704 represents the pressure applied on a second key (illustrated as the key corresponding to the letter "F"), line 2706 represents the pressure applied on a third key (illustrated as the key corresponding to the letter "J"), line 2708 represents the pressure applied on a fourth key (illustrated as the key corresponding to the letter "D"), and line 2710 represents the pressure applied on a fifth key. Even though the pressure on the fifth key rises to the selection threshold amount (e.g., 800 grams) and/or the slope of the line 2710 rises to a threshold slope (e.g., 20 grams/millisecond) during a monitoring period, the fifth key is not determined to be struck because the number of keys pressed concurrently has reached the key press count threshold when the fifth key is pressed. The key press count threshold is one higher in the example 2700 than in the example 2600 of FIG. 26 because one of the keys in the example 2700 is a modifier key. No more keys are determined to be struck until the pressure applied to the keys drops to the key release threshold amount. The key strikes for the keys corresponding to the letters "F", "D", and "J" may still be maintained as key strikes, but no more keys are determined to be struck until the pressure applied to the keys drops to the key release threshold amount. Alternatively, in response to the number of keys pressed concurrently reaching the key press count threshold, the previously determined key strikes for the keys corresponding to the letters "F", "D", and "J" may be deleted or ignored, so that those key strikes are no longer determined to be key strikes.

FIG. 28 depicts an example 2800 of a graph of pressure on multiple keys concurrently over time illustrating invalid key presses resulting from concurrently pressed keys. Example 2800 is similar to the example 1800 of FIG. 16, except that each key is determined to be struck in response the pressure on the key rising to the selection threshold amount (e.g., 800 grams) and/or the slope of the line graphing the pressure of the key over time rising to a threshold slope (e.g., 20 grams/millisecond) during a monitoring period (not shown), rather than the pressure applied to the key simply rising to the key press threshold amount.

In response to the pressure applied to a first key, illustrated as the key corresponding to the letter "f", rising to the selection threshold amount (e.g., 800 grams) and/or the slope of the line graphing the pressure of the key over time rising to a threshold slope (e.g., 20 grams/millisecond) during a monitoring period (not shown), at point 2802, the first key is determined as being struck at point 2802. Line 2804 represents the pressure applied on the first key over a first period of time. The first key remains pressed or struck until the pressure on the first key drops to the key release threshold amount (e.g., 100 grams)

Pressure is also applied to a second key concurrently with pressure being applied to the first key. Line 2806 represents the pressure applied on the second key over a second period of time. Pressure is also applied to a third key concurrently with pressure being applied to the first and second keys. Line 2808 represents the pressure applied on the third key over a third period of time. A different key rejection amount of time 2810 (e.g., 40 ms is also illustrated, beginning at the time the pressure applied to the first key rises to the key press threshold amount). Even though the pressures applied on the second and third keys rise to the selection threshold amount (e.g., 800 grams) and/or the slope of the lines 2806 and 2808 rise to a threshold slope (e.g., 20 grams/millisecond) during a monitoring period for each key, the second and third keys are not determined to be struck because the different key rejection amount of time has not elapsed at the points where the pressures applied on the second and third keys rise to the selection threshold amount (e.g., 800 grams) and/or the slope of the lines 2806 and 2808 rise to a threshold slope.

Furthermore, pressure is also applied to a fourth key concurrently with pressure being applied to the first, second, and third keys. Line 2812 represents the pressure applied on the fourth key over a fourth period of time. A record is maintained that the pressures applied to the second and third keys rose to the key press threshold amount even though the pressures applied were not determined to be key strikes. Thus, the second and third keys are included in the key press count. Therefore, even though the pressure on the fourth key rises to the key press threshold amount after the different key rejection amount of time 2810 elapses, the fourth key is not determined to be struck because the number of keys pressed concurrently has reached the key press count when the fourth key is pressed. Thus, no more keys are determined to be struck until the pressure applied to the keys drops to the key release threshold amount. The key strikes for the key corresponding to the letter "f' may still be maintained as a key strike, but no more keys are determined to be struck until the pressure applied to the keys drops to the key release threshold amount. Alternatively, in response to the number of keys pressed concurrently reaching the key press count threshold, the previously determined key strike for the key corresponding to the letter "f' may be deleted or ignored, so that that key strike is no longer determined to be a key strike.

In many of the examples above, a key strike is discussed as being determined in response to the pressure applied to a key rising to a particular amount (e.g., the key press threshold amount or the selection threshold amount). Alternatively, key strikes can be determined in response to other pressures applied. For example, a key strike may be determined in response to the pressure on a key rising to a particular amount (e.g., the key press threshold amount or the selection threshold amount), and then dropping to another amount (optionally within a particular time duration). By way of another example, various characteristics of a key press may be analyzed over time and compared to characteristics of a key strike, and the key press determined to be a key strike if the analysis determines that the characteristics of the key press match those of a key strike.

Although the key strike may be determined in response to other pressures applied, the various other factors discussed above optionally still apply. For example, the same key rejection amount of time and different key rejection amount of time discussed above may apply, although the timing of when the key strike is determined is changed.

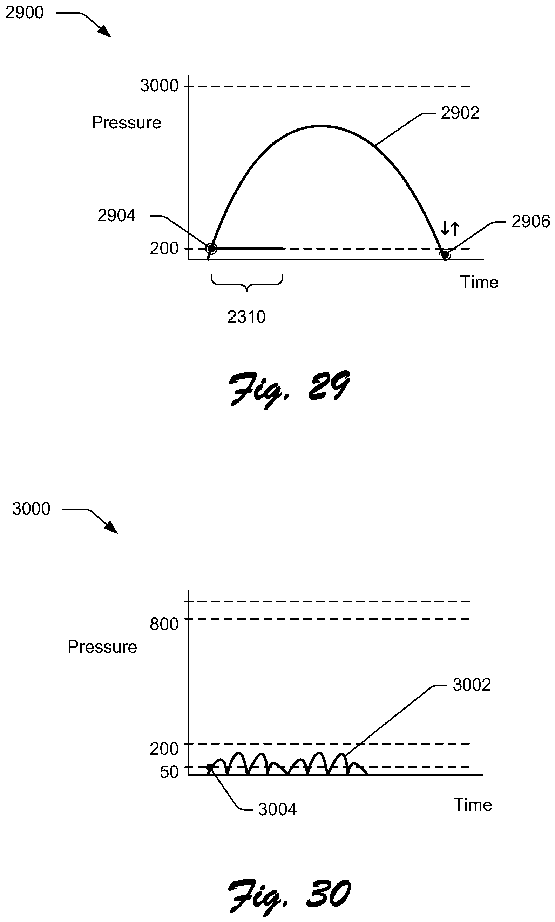

FIG. 29 depicts an example 2900 of a graph of pressure on one key over time illustrating a key strike. A line 2902 represents the pressure on the key over time. In response to the pressure on the key rising to (e.g., equal to and/or greater than) a key press threshold amount at point 2904, and subsequently dropping to (e.g., equal to and/or less than) a key release threshold amount at point 2906, the key is determined as being struck at point 2906. The key is also determined to be immediately released after being struck at point 2906. A de-bounce amount of time 2908 (e.g., 40 ms) is also illustrated, beginning at the time the key is determined to be pressed at point 2904.

A threshold time duration may also be imposed, so that the pressure on the key is determined to be a key strike only in response to the time between points 2904 and 2906 being less than a threshold time duration. This threshold time duration may be 130 ms, although other time durations are contemplated. This threshold time duration can be used, for example, to facilitate distinguishing between users that are "light typists" (e.g., users that apply light pressure to the keyboard when typing) and users that are "heavy resters" (e.g., users that apply heavy pressure to the keyboard when resting fingers and/or hands on the keyboard). Such "light typists" and "heavy resters" may apply similar amounts of pressure, but can be distinguished between based on this threshold time duration (e.g., a user resting his or her fingers or hands on the keyboard would typically not release pressure within this threshold duration of time).

In addition to determining key strikes, the pressure applied to one or more keys of the keyboard can be used to protect the input device against inadvertent inputs. For example, light pressure to one or more keys may be determined to be the user resting his or her hands or fingers on the keyboard. This light pressure can be, for example, an amount of pressure greater than a resting threshold amount (e.g., 50 grams, although other amounts are contemplated) but less than the key press threshold amount.

In response to such light pressure being detected, other input components of the input device (e.g., a touchpad, orientation sensing systems, etc.) can be disabled so that inadvertent user touches or movements are not incorrectly identified as inputs to those other components. Disabling an input component refers to powering down the input component or placing the input component in a low power mode so that the input component does not sense user inputs. Disabling such other input components can also provide power savings because those input components are not using as much power when disabled.

FIG. 30 depicts an example 3000 of a graph of pressure on a key over time illustrating a resting position. A line 3002 represents the pressure on the key over time. In response to the pressure on the key rising to (e.g., equal to and/or greater than) resting threshold amount at point 3004, a determination is made that the user is resting his or her fingers or hands on the keyboard. This determination can last until one or more events occur to indicate that the user is no longer resting his or her hands on the keyboard. Such events may include a key strike being determined as discussed above, the pressure on the keys dropping to (e.g., equal to and/or less than) a threshold amount (e.g., zero grams, although other amounts are contemplated), and so forth.

Similarly, the operation of the pressure sensitive keyboard and other input components can be coordinated, allowing actions by certain components to result in other components being disabled. For example, a touchpad or orientation sensing system can be disabled when key strikes are being detected by the user. By way of another example, the pressure sensitive keyboard can be disabled when user inputs are being received via the touchpad.

Furthermore, the light pressure illustrated in example 3000 being detected on particular keys that a user is typically drawn to, such as the "f" and/or "j" keys on a QWERTY keyboard or other "home" keys, a homing behavior is detected. This homing behavior is referred to as a user attempting to locate these home keys. Other components or modules of the input device can optionally be enabled or activated in response to the homing behavior being detected. For example, a feedback component providing feedback (e.g., haptic, audible, visual, etc.) to the user in response to key strikes can be activated or enabled in response to such light pressure being detected on particular (e.g., "home") keys.

It should be noted that the input device 104 discussed above (e.g., with reference to FIGS. 1-2) can include a touchpad or track pad. Buttons (oftentimes referred to as mouse buttons) can be associated with the touchpad or track pad, and those buttons can be pressure sensitive keys as discussed above. Thus, whether a user input is selection of such a button is determined based on whether the user input is a key strike as discussed above.

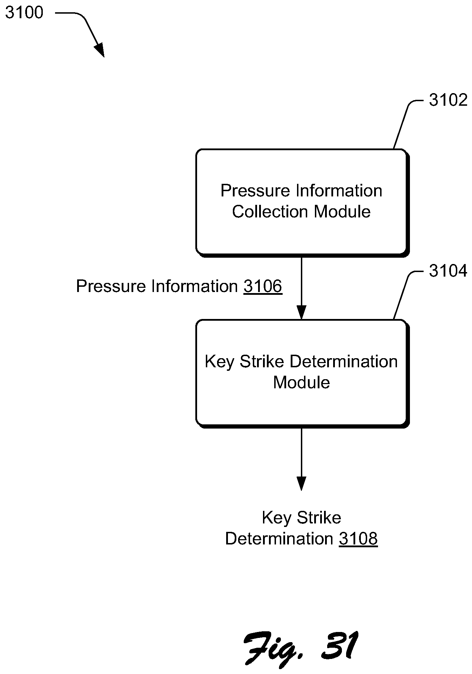

FIG. 31 is an illustration of a system 3100 in an example implementation that is operable to employ the techniques described herein. The system 3100 includes a pressure information collection module 3102 and a key strike determination module 3104. System 3100 may be implemented, for example, in the input device 104 and/or the computing device 102 of FIG. 1, or the input device 104 of FIG. 2. Thus, for example, module 3102 may be implemented in input device 104 and module 3104 may be implemented in computing device 102, both modules 3102 and 3104 may be implemented in input device 104, and so forth.

Pressure information collection module 3102 obtains an indication of the amount of pressure applied to the keys of the pressure sensitive keyboard. Module 3102 obtains (e.g., receives and/or generates) pressure information 3106 regarding user inputs to the keyboard of the input device, and provides the pressure information 3106 to the key strike determination module 3104. Based on the pressure information 3106, key strike determination module 3104 determines one or more keys that are struck and outputs an indication 3108 of this determination. This determination is made based on the pressure applied to the keys, and optionally various other factors as discussed above.

In one or more embodiments, key strike determination module 3104 uses the pressure and optionally various other factors discussed above as follows. Each frame, the keys of the keyboard are analyzed. One or more keys are referred to as newly pressed, which refers to the one or more keys having risen to the key press threshold amount in the frame being analyzed.

If the key is newly pressed, and the initial key pressure is in an indeterminate range (e.g., between the key press threshold amount and the selection threshold amount), and the key is not already currently being monitored to determine if it is a key strike or an inadvertent actuation, then the initial pressure and current time (e.g., tick count) are recorded, and a key state or record is changed to indicate the key is to be monitored further to determine if the pressure applied is a key strike or not.

Otherwise, if the key is newly pressed, and the key is currently being monitored, and the current pressure has risen to the selection threshold amount, then the pressure applied is determined to be a key strike if any additional factors are satisfied. Various additional factors can be used as discussed above, such as a hysteresis factor, an amount of time since the key was released, an amount of time since a different key was determined to be struck, a key press count, and so forth.

Otherwise, if the key has been monitored for more than the monitoring period without the determination that the pressure applied is a key strike, then various state tracking information is cleared. The key can optionally be recorded as being de-bounced, so that the key is not recorded as being released until the de-bounce amount of time has elapsed.

Otherwise, if a key is still being pressed or de-bounced, a check is made as to whether the key is a mouse button key. If the key is a mouse button key, then a variable or other record is updated to indicate the mouse button states (optionally left and right mouse button states). If the key is not a mouse button key, then the current time (e.g., tick count) is recorded. This recorded time can be used to hold off track pad activity for a particular amount of time (e.g., a particular number of milliseconds) based on an assumption that the key press was an inadvertent press by the user.

Otherwise, if a key has just been released (e.g., the key was currently being tracked as being pressed, such as by having a key state of "waiting for key to be released", and the current pressure value has dropped to the key release threshold amount), the key can be considered "newly released". The key state is set as no longer being pressed and the current time (e.g., tick count) is recorded, which may be used to prevent keys from being reported as pressed too soon after being released. If the newly released key is a not a modifier key, then the variable or other record tracking the number of currently pressed non-modifier keys is decremented. This count is used to determine whether the key press count threshold is reached, as discussed above.

Otherwise, a key is not being pressed or monitored. If a hysteresis count is being maintained to support the hysteresis factor discussed above, the hysteresis count can be cleared.

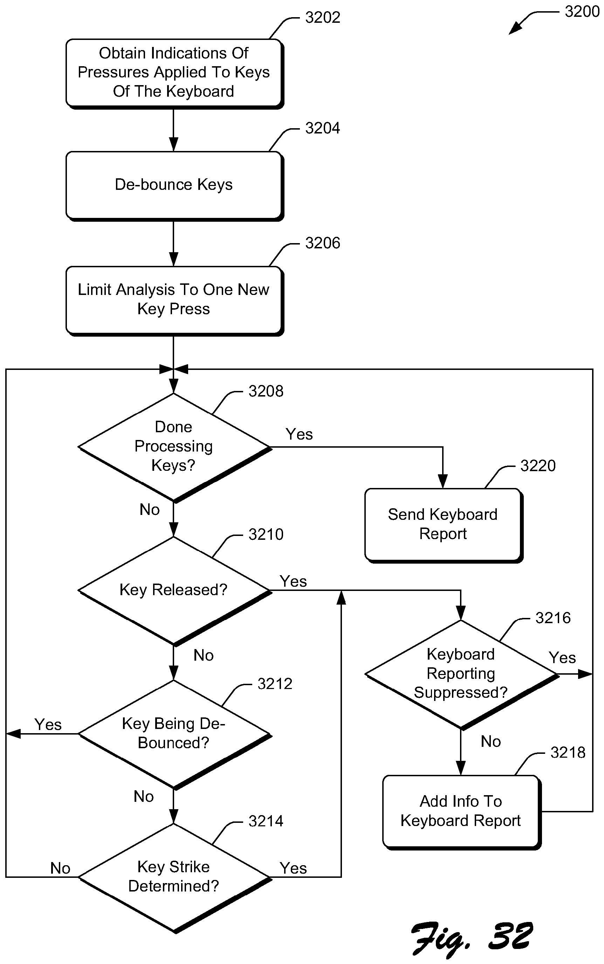

FIG. 32 is a flowchart illustrating an example process 3200 for implementing the techniques described herein in accordance with one or more embodiments. Process 3200 is carried out by a key strike determination module, such as key strike determination module 3104 of FIG. 31, and can be implemented in software, firmware, hardware, or combinations thereof. Process 3200 is shown as a set of acts and is not limited to the order shown for performing the operations of the various acts. Process 3200 is an example process for implementing the techniques described herein; additional discussions of implementing the techniques described herein are included herein with reference to different figures.

In process 3200, indications of pressures applied to keys of the keyboard are obtained for a frame (act 3202). These indications can be received from the sensor substrate of the pressure sensitive keyboard as discussed above, or alternatively received from other components or modules. Process 3200 is repeated for each frame.

Any keys for which the de-bounce amount of time has expired are de-bounced (act 3204). De-bouncing a key refers to recording that the de-bounce amount of time has elapsed for the key, so that the key can be determined as being released when the pressure applied to the key drops, as discussed above. This recording can be performed in various manners, such as by transitioning a key from a "de-bounce" state to a "wait for release" state.

Analysis of whether a key strike has been made is limited to one new key press per frame (act 3206). A new key press refers to the pressure applied to a key that was last recorded as released rising to the key press threshold amount. Keys can optionally be maintained in a "released" state or a "pressed:" state, in which case a new key press refers to the pressure applied to a key in the "released" state rising to the key press threshold amount. If multiple keys that were last recorded as released rise to the key press threshold amount for a frame, then one of the multiple keys is selected in act 3206. The key selected may be the key to which the greatest pressure is applied in the frame. If the same pressure is applied to multiple keys, then one of those is selected (e.g., a first key encountered when analyzing keys in act 3206, randomly, according to some ranking or priority level of keys, and so forth) and the recorded pressure applied to the non-selected key or keys can be reduced (e.g., by 1 gram). Alternatively, the key may be selected in other manners rather than based on pressure, such as randomly, according to a ranking or priority level of keys, and so forth.

Alternatively, process 3200 may not include act 3206. In such situations, analysis of a key strike is not limited to one new key press per frame, and may include multiple new key presses per frame.

Process 3200 proceeds based on whether all the keys have been processed for the frame (act 3208). Processing of the frame refers to analyzing the key as discussed below in acts 3210-3220. Each key is typically processed, as some keys may be released. Alternatively, only keys that are currently in a "pressed" state and the key that is the one new key press identified in act 3206 may be processed.

If processing of keys is not done, then an unprocessed key is selected and a determination made as to whether the selected key has been released (act 3210). The selected key is released if the key is recorded as pressed (e.g., in a "pressed" state) and the pressure applied to the key drops to the selected key release threshold amount.

If the selected key is not released, then a check is made as to whether the selected key is being de-bounced (act 3212). The selected key is being de-bounced for the duration of the de-bounce amount of time as discussed above. A counter or other tracking mechanism can be used for a key to determine when the key is being de-bounced.

If the selected key is being de-bounced, then process 3200 returns to act 3208 to check whether all the keys have been processed for the frame. However, if the selected key is not being de-bounced, then a check is made as to whether the selected key is determined to have been struck (act 3214). Whether the selected key is determined to have been struck in the frame is based on the pressure applied to the key and one or more of various other factors, as discussed above. The determination of whether the key has been struck can be performed for a single key per frame (e.g., the key selected in act 3206 as discussed above), or alternatively for multiple keys per frame. Whether the selected key was struck can be based on determining whether the pressure applied to the key rises to the key press threshold amount (and optionally additional factors as discussed above). Alternatively, whether the selected key was struck can be based on determining whether the pressure applied to the key rises to the selection threshold amount and/or the slope of the line graphing the pressure applied to the key over time rises to a threshold slope during a monitoring period (and optionally additional factors as discussed above).

If the selected key is not determined to have been struck, then process 3200 returns to act 3208 to check whether all the keys have been processed for the frame. However, if the selected key has been determined to have been struck then a check is made as to whether keyboard reporting is suppressed (act 3216). Keyboard reporting can be suppressed for various different reasons, such as system performance, power savings, and so forth.

If keyboard reporting is suppressed, then process 3200 returns to act 3208 to check whether all the keys have been processed for the frame. However, if keyboard reporting is not suppressed, then an indication that the selected key was determined to have been struck is added to a keyboard report. The keyboard report can include various information regarding the key strike, such as an identification of the key that was struck, a time that the key was struck, and so forth. Process 3200 then returns to act 3208 to check whether all the keys have been processed for the frame.

Returning to act 3210, if the selected key is released, then a check is made as to whether keyboard reporting is suppressed (act 3216). If keyboard reporting is suppressed, then process 3200 returns to act 3208 to check whether all the keys have been processed for the frame. However, if keyboard reporting is not suppressed, then an indication that the selected key was released is added to a keyboard report. The keyboard report can include various information regarding the released key, such as an identification of the key that was released, a time that the key was released, and so forth. Process 3200 then returns to act 3208 to check whether all the keys have been processed for the frame.

Returning to act 3208, if all the keys have been processed for the frame, the keyboard report (if one is available) is sent (act 3220). The keyboard report can be sent to various components or modules, such as input/output module 108 of FIG. 1, another module or component of input device 104 of FIG. 1 and FIG. 2, and so forth.

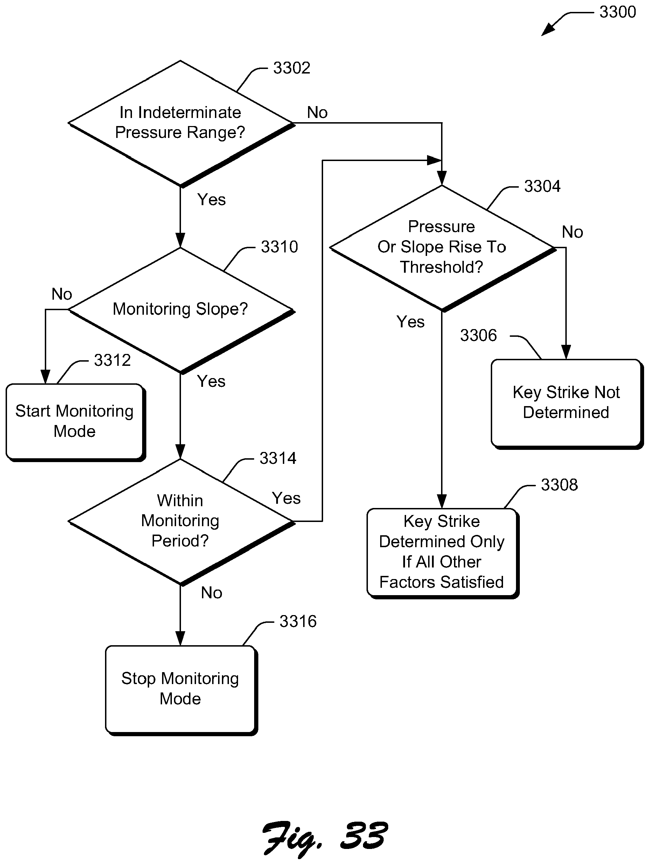

FIG. 33 is a flowchart illustrating an example process 3300 for determining whether a key strike occurs in accordance with one or more embodiments. Process 3300 is carried out by a key strike determination module, such as key strike determination module 3104 of FIG. 31, and can be implemented in software, firmware, hardware, or combinations thereof. Process 3300 can implement, for example, act 3214 of FIG. 32. Process 3300 is shown as a set of acts and is not limited to the order shown for performing the operations of the various acts. Process 3300 is an example process for implementing the techniques described herein; additional discussions of implementing the techniques described herein are included herein with reference to different figures.

In process 3300, a check is made as to whether the pressure applied to the key is in an indeterminate range (act 3302). The indeterminate range refers to the range between the key press threshold amount (e.g., 200 grams) and the selection threshold amount (e.g., 800 grams). If the pressure applied to the key is not in the indeterminate range, then a check is made as to whether the pressure applied to the key rises to the selection threshold amount (act 3304). If the pressure applied to the key does not rise to the selection threshold amount, then the key is determined to not be struck (act 3306). An indication that the key is determined to not be struck can optionally be returned (e.g., for inclusion in a keyboard report as discussed above).

However, if the pressure applied to the key does rise to the selection threshold amount, then the key is determined to be struck if all other factors are also satisfied (act 3308). Various different factors can be applied as discussed above, such as a hysteresis factor, an amount of time since the key was released, an amount of time since a different key was determined to be struck, a key press count, and so forth. An indication that the key is determined to have been struck can optionally be returned (e.g., for inclusion in a keyboard report as discussed above).

Returning to act 3302, if the pressure applied to the key is in the indeterminate range, then a check is made as to whether the slope of the key is already being monitored (act 3310). The pressure applied to the key can have risen to the key press threshold amount in a previous frame, and the key can currently be in the monitoring period, as discussed above, and thus the slope of the key can already be monitored.

If the slope of the key is not already monitored, then monitoring of the key is started (act 3312). A record that the key is being monitored is maintained and can be used when processing subsequent frames. This record can be, for example, transitioning the key to a "monitoring pressure change" state.

However, if the slope of the key is already being monitored, then a check is made as to whether the key is still within the monitoring period (act 3314). If the key is still within the monitoring period, then a check is made as to whether the slope of the graph of the pressure applied to the key over time (the rate of the key pressure applied to the key) rises to the threshold slope (act 3304). If the slope of the graph does not rise to the threshold slope, then the key is determined to not be struck (act 3306). An indication that the key is determined to not be struck can optionally be returned (e.g., for inclusion in a keyboard report as discussed above).

However, if the slope of the graph does rise to the threshold slope, then the key is determined to be struck if all other factors are also satisfied (act 3308). Various different factors can be applied as discussed above.

Returning to act 3314, if the key is not still within the monitoring period, then the monitoring of the slope of the key is stopped (act 3314). A record that the key is no longer being monitored is maintained and can be used when processing subsequent frames. This record can be, for example, transitioning the key to an "initial" state.

It should also be noted that the input device 104 can provide various feedback to the user in response to key strikes. This feedback can take various forms, such as audible (e.g., a chime or ping each time a key is determined as being struck), haptic (e.g., a shaking of the input device each time a key is determined as being struck), visual (e.g., the key that is struck lighting up or a light emitting diode (LED) illuminating each time a key is determined as being struck), and so forth.

It should also be noted that, although each individual key is discussed above as being a pressure sensor, alternatively multiple pressure sensors can be associated with a key. For example, each key can incorporate any number of pressure sensors analogous to the pressure sensors discussed above. By way of another example, the input device may include a dense array of pressure sensors (e.g., 1500 or more sensors) with different groups of sensors being associated with different keys of the keyboard. In such situations, the pressure applied to the key is based on a combination of (e.g., a sum or other function of) the pressure applied to the pressure sensors associated with the key.

In the discussions above, various different amounts, thresholds, durations, and so forth are discussed. These include, for example, the key press threshold amount, the hysteresis value, the key release threshold amount, the key press duration, the same key rejection time threshold, the different key rejection time threshold, the key press count threshold, the monitoring amount of time, and so forth. Example values for these various amounts, thresholds, durations, and so forth are discussed, although these are examples and other values are contemplated. Furthermore, the specific values that are used for these various amounts, thresholds, durations, and so forth can vary based on different system configurations, settings, and so forth.

For instance, different values can be used for these various amounts, thresholds, durations, and so forth based on the size or characterization of the pressure sensor or key. E.g., a small key or small sensors that have less sensitivity may have lower key press threshold and lower key release threshold amounts than larger keys or larger sensors that have greater sensitivity. Furthermore, different values can be used for different pressure sensors or keys on the same input device. E.g., smaller keys (e.g., with a surface area less than a threshold size) may have lower key press threshold and lower key release threshold amounts than larger keys.

In another instance, the values that are used for these various amounts, thresholds, durations, and so forth can be set as part of a user customization process. The user customization process may be a training process, in which the user is presented with multiple sentences or other strings of characters to type. The user presses the appropriate keys to input the sentences or other strings, and the various parameters (e.g., pressures applied, timings between characters, etc.) of the user's key presses are evaluated and used to customize these values. As the sentences or other strings are known, what keys are intended to be struck by the user are known, and a user pressing of a key may be identified as a selection of the key even if the pressure applied would not otherwise be determined to be a key strike. For example, the amount of pressure that the user typically applies when entering a key can be identified, and the key press threshold amount and/or selection threshold amount can be modified based on this pressure (e.g., the key press threshold amount can be lowered to 150 grams if the user is a light typist and typically applies pressure of 500 grams when striking a key, or the selection threshold amount can be raised to 1000 grams if the user is a heavy typist that typically applies pressure of 1200 grams when striking a key).

The user customization process may also be a user input specifying particular values for a user. For example, a user interface may be presented to the user via which the user can identify particular values for these various amounts, thresholds, durations, and so forth. The particular values can be specified in different manners, such as by the user inputting numerical values (e.g., entering "180" in a data entry field to indicate the key press threshold amount is to be 180 grams), by selecting a setting along a sliding scale or dial, and so forth. The user may also be able to select from multiple settings, each setting having different associated values for the various amounts, thresholds, durations, and so forth. For example, the user may be able to select between settings of "light", "average", and "heavy" to indicate an amount of pressure they typically apply when striking keys, and these different settings may have different key press and/or selection threshold amounts (e.g., lower threshold amounts for lighter typists than for heavier typists). By way of another example, the user may be able to select between settings of "slow", "average", and "fast" to indicate how quickly they type, and these different settings may have different same key and/or different key rejection amounts of time (e.g., longer amounts of time for faster typists than for slower typists).

In situations in which different values can be set for these various amounts, thresholds, durations, and so forth as part of a user customization process, the values can be maintained over time for the user. For example, the values can be associated with a user account, so that each time the user logs into the computing device, the values he or she previously customized are retrieved and used while he or she is logged into the device.

Different configurations of the computing device, orientations of the computing device, applications running on the computing device, and so forth can also have different values for these various amounts, thresholds, durations, and so forth. The values can be default values for a particular configuration, orientation, application, and so forth, and/or the values for a particular configuration, orientation, application, and so forth can be set as part of a user customization process. For example, a particular game may have a smaller different key rejection time threshold and/or a higher key press count threshold than a word processing application. By way of another example, the monitoring amount of time and/or the de-bounce amount of time may be longer if the input device is laid flat against the back side of the display device than if the input device and display device are both laid flat against a surface.

Additionally, although specific amounts, thresholds, durations, and so forth are discussed, additional amounts, thresholds, and/or durations can also be used. For instance, one or more additional pressure threshold amounts can be used to determine, after a key strike is determined, a particular manner in which the character corresponding to the selected key is to be presented. This manner can be different font sizes, font types, font weights, font styles (e.g., bold-faced, underlined, etc.), and so forth. E.g., if the pressure applied to a key rises to 2000 grams before the key is released, then the character may be displayed bold-faced, but displayed in normal (non-bold-faced) if the pressure does not rise to 2000 grams.

In another instance, additional pressure threshold amounts can be used to determine, after a key strike is determined, a particular manner in which feedback to the user in response to the key strike is provided. For example, one or more additional pressure threshold amounts can be used to determine, after a key strike is determined, a volume level for audible feedback. E.g., if the pressure applied to a key rises to 1500 grams before the key is released, then the feedback may be louder than if the pressure does not rise to 1500 grams. Or, if the pressure applied to a key rises to 1500 grams before the key is released, then both audible and haptic feedback may be provided, but only haptic feedback provided if the pressure does not rise to 1500 grams.

The key strike determination for pressure sensitive keyboard techniques discussed herein support various usage scenarios. The techniques allow key strikes to a pressure sensitive keyboard to be readily identified, allowing a user to easily and quickly provide inputs via the keyboard. Furthermore, these techniques allow key strikes to be readily differentiated from other inputs that would not be intended by the user to be key strikes, such as a user resting his or her hands or fingers on the keyboard, a user moving fingers over a keyboard to find the home position, inadvertent touches, and so forth.

### Example System and Device

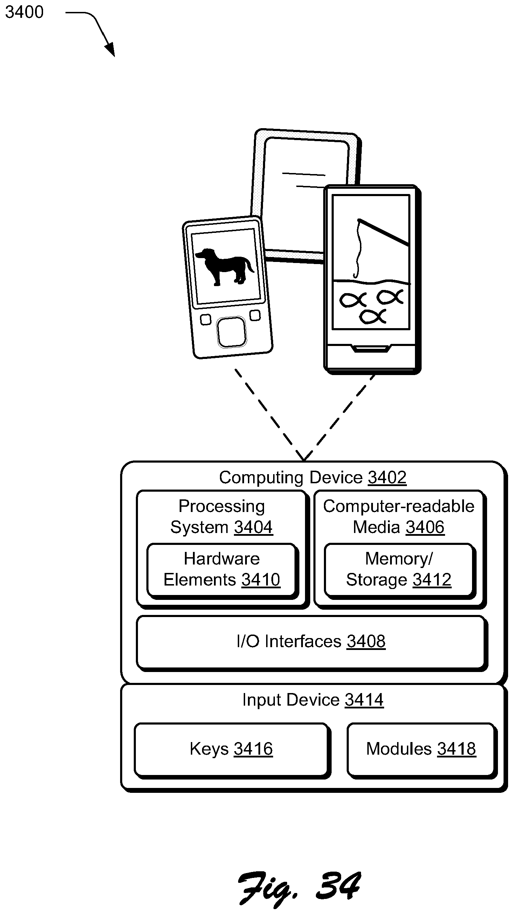

FIG. 34 illustrates an example system generally at 3400 that includes an example computing device 3402 that is representative of one or more computing systems and/or devices that may implement the various techniques described herein. The computing device 3402 may, for example, be configured to assume a mobile configuration through use of a housing formed and size to be grasped and carried by one or more hands of a user, illustrated examples of which include a mobile phone, mobile game and music device, and tablet computer although other examples are also contemplated.

The example computing device 3402 as illustrated includes a processing system 3404, one or more computer-readable media 3406, and one or more I/O interface 3408 that are communicatively coupled, one to another. Although not shown, the computing device 3402 may further include a system bus or other data and command transfer system that couples the various components, one to another. A system bus can include any one or combination of different bus structures, such as a memory bus or memory controller, a peripheral bus, a universal serial bus, and/or a processor or local bus that utilizes any of a variety of bus architectures. A variety of other examples are also contemplated, such as control and data lines.

The processing system 3404 is representative of functionality to perform one or more operations using hardware. Accordingly, the processing system 3404 is illustrated as including hardware element 3410 that may be configured as processors, functional blocks, and so forth. This may include implementation in hardware as an application specific integrated circuit or other logic device formed using one or more semiconductors. The hardware elements 3410 are not limited by the materials from which they are formed or the processing mechanisms employed therein. For example, processors may be comprised of semiconductor(s) and/or transistors (e.g., electronic integrated circuits (ICs)). In such a context, processor-executable instructions may be electronically-executable instructions.

The computer-readable storage media 3406 is illustrated as including memory/storage 3412. The memory/storage 3412 represents memory/storage capacity associated with one or more computer-readable media. The memory/storage component 3412 may include volatile media (such as random access memory (RAM)) and/or nonvolatile media (such as read only memory (ROM), Flash memory, optical disks, magnetic disks, and so forth). The memory/storage component 3412 may include fixed media (e.g., RAM, ROM, a fixed hard drive, and so on) as well as removable media (e.g., Flash memory, a removable hard drive, an optical disc, and so forth). The computer-readable media 3406 may be configured in a variety of other ways as further described below.

Input/output interface(s) 3408 are representative of functionality to allow a user to enter commands and information to computing device 3402, and also allow information to be presented to the user and/or other components or devices using various input/output devices. Examples of input devices include a keyboard, a cursor control device (e.g., a mouse), a microphone, a scanner, touch functionality (e.g., capacitive or other sensors that are configured to detect physical touch), a camera (e.g., which may employ visible or non-visible wavelengths such as infrared frequencies to recognize movement as gestures that do not involve touch), and so forth. Examples of output devices include a display device (e.g., a monitor or projector), speakers, a printer, a network card, tactile-response device, and so forth. Thus, the computing device 3402 may be configured in a variety of ways to support user interaction.

The computing device 3402 is further illustrated as being communicatively and physically coupled to an input device 3414 that is physically and communicatively removable from the computing device 3402. In this way, a variety of different input devices may be coupled to the computing device 3402 having a wide variety of configurations to support a wide variety of functionality. In this example, the input device 3414 includes one or more keys 3416, which may be configured as pressure sensitive keys, mechanically switched keys, and so forth.

The input device 3414 is further illustrated as include one or more modules 3418 that may be configured to support a variety of functionality. The one or more modules 3418, for instance, may be configured to process analog and/or digital signals received from the keys 3416 to determine whether a keystroke was intended, determining whether pressure applied to a key is a key strike, determine whether an input is indicative of resting pressure, support authentication of the input device 3414 for operation with the computing device 3402, and so on. Modules 3418 can include, for example, module 3102 and/or module 3104 of FIG. 31.

Various techniques may be described herein in the general context of software, hardware elements, or program modules. Generally, such modules include routines, programs, objects, elements, components, data structures, and so forth that perform particular tasks or implement particular abstract data types. The terms "module," "functionality," and "component" as used herein generally represent software, firmware, hardware, or a combination thereof. The features of the techniques described herein are platform-independent, meaning that the techniques may be implemented on a variety of commercial computing platforms having a variety of processors.

An implementation of the described modules and techniques may be stored on or transmitted across some form of computer-readable media. The computer-readable media may include a variety of media that may be accessed by the computing device 3402. By way of example, and not limitation, computer-readable media may include "computer-readable storage media" and "computer-readable signal media."

"Computer-readable storage media" may refer to media and/or devices that enable persistent and/or non-transitory storage of information in contrast to mere signal transmission, carrier waves, or signals per se. Thus, computer-readable storage media refers to non-signal bearing media. The computer-readable storage media includes hardware such as volatile and non-volatile, removable and non-removable media and/or storage devices implemented in a method or technology suitable for storage of information such as computer readable instructions, data structures, program modules, logic elements/circuits, or other data. Examples of computer-readable storage media may include, but are not limited to, RAM, ROM, EEPROM, flash memory or other memory technology, CD-ROM, digital versatile disks (DVD) or other optical storage, hard disks, magnetic cassettes, magnetic tape, magnetic disk storage or other magnetic storage devices, or other storage device, tangible media, or article of manufacture suitable to store the desired information and which may be accessed by a computer.

"Computer-readable signal media" may refer to a signal-bearing medium that is configured to transmit instructions to the hardware of the computing device 3402, such as via a network. Signal media typically may embody computer readable instructions, data structures, program modules, or other data in a modulated data signal, such as carrier waves, data signals, or other transport mechanism. Signal media also include any information delivery media. The term "modulated data signal" means a signal that has one or more of its characteristics set or changed in such a manner as to encode information in the signal. By way of example, and not limitation, communication media include wired media such as a wired network or direct-wired connection, and wireless media such as acoustic, RF, infrared, and other wireless media.

As previously described, hardware elements 3410 and computer-readable media 3406 are representative of modules, programmable device logic and/or fixed device logic implemented in a hardware form that may be employed in some embodiments to implement at least some aspects of the techniques described herein, such as to perform one or more instructions. Hardware may include components of an integrated circuit or on-chip system, an application-specific integrated circuit (ASIC), a field-programmable gate array (FPGA), a complex programmable logic device (CPLD), and other implementations in silicon or other hardware. In this context, hardware may operate as a processing device that performs program tasks defined by instructions and/or logic embodied by the hardware as well as a hardware utilized to store instructions for execution, e.g., the computer-readable storage media described previously.

Combinations of the foregoing may also be employed to implement various techniques described herein. Accordingly, software, hardware, or executable modules may be implemented as one or more instructions and/or logic embodied on some form of computer-readable storage media and/or by one or more hardware elements 3410. The computing device 3402 may be configured to implement particular instructions and/or functions corresponding to the software and/or hardware modules. Accordingly, implementation of a module that is executable by the computing device 3402 as software may be achieved at least partially in hardware, e.g., through use of computer-readable storage media and/or hardware elements 3410 of the processing system 3404. The instructions and/or functions may be executable/operable by one or more articles of manufacture (for example, one or more computing devices 3402 and/or processing systems 3404) to implement techniques, modules, and examples described herein.

### Conclusion

Although the example implementations have been described in language specific to structural features and/or methodological acts, it is to be understood that the implementations defined in the appended claims is not necessarily limited to the specific features or acts described. Rather, the specific features and acts are disclosed as example forms of implementing the claimed features.

## Claims

1. A method comprising:
obtaining an indication of pressure applied to a key (400; 500; 600; 700; 800; 902; 904) of a pressure sensitive keyboard (900) configured to be physically and communicatively removable from a computing device (102; 3402);
determining how many other keys have been pressed and are still pressed, wherein another key is considered as pressed when the pressure applied to the other key is equal or greater than a key press threshold amount; and
determining that the pressure applied to the key is a key strike in response to the pressure applied to the key rising to a key press threshold amount and no more than a threshold number of other keys concurrently being pressed.

2. A method as recited in claim 1, the determining comprising determining that the pressure applied to the key (400; 500; 600; 700; 800; 902; 904) is a key strike in response to both the pressure applied to the key rising to the key press threshold amount and a threshold amount of time having elapsed since the key was previously struck and released.

3. A method as recited in claim 1, the determining comprising determining that the pressure applied to the key (400; 500; 600; 700; 800; 902; 904) is a key strike in response to both the pressure applied to the key rising to the key press threshold amount and a threshold amount of time having elapsed since a different key of the keyboard (900) was previously struck.

4. A method as recited in claim 1, the key press threshold amount varying for different keys (902; 904) of the keyboard (900).

5. A method as recited in claim 1, further comprising identifying a particular value for the key press threshold amount for a user as part of a user customization process.

6. A method as recited in claim 1, further comprising determining the key press threshold amount based at least in part on a configuration of the computing device (102; 3402), an orientation of the computing device, and/or an application running on the computing device.

7. A method as recited in claim 1, further comprising determining, after determining that the pressure applied to the key (400; 500; 600; 700; 800; 902; 904) is a key strike and based on the pressure applied to the key, a manner in which a character corresponding to the key is to be presented and/or a manner in which feedback to the user in response to the key strike is to be provided.

## Patentansprüche

1. Verfahren, das Folgendes umfasst:
Erhalten einer Anzeige eines auf eine Taste (400; 500; 600; 700; 800; 902; 904) einer druckempfindlichen Tastatur (900), dazu ausgelegt, physisch und kommunikativ von einer Datenverarbeitungsvorrichtung (102; 3402) entfernbar zu sein, gewirkten Drucks;
Bestimmen, wie viele andere Tasten gedruckt wurden und immer noch gedrückt werden, wobei eine andere Taste als gedrückt erachtet wird, wenn der auf die andere Taste gewirkte Druck gleich oder größer als ein Tastendruckschwellbetrag ist; und
Bestimmen, dass der auf eine Taste gewirkte Druck ein Tastenanschlag ist, in Reaktion darauf, dass der auf die Taste gewirkte Druck auf einen Tastendruckschwellbetrag ansteigt und dass nicht mehr als eine Schwellenanzahl von anderen Tasten gleichzeitig gedrückt wird.

2. Verfahren nach Anspruch 1, wobei das Bestimmen umfasst zu bestimmen, dass der auf die Taste (400; 500; 600; 700; 800; 902; 904) gewirkte Druck ein Tastenanschlag ist, in Reaktion darauf, dass sowohl der auf die Taste gewirkte Druck auf den Tastendruckschwellbetrag ansteigt und dass eine Schwellenzeitspanne verstrichen ist, seit die Taste vorher gedrückt und losgelassen wurde.

3. Verfahren nach Anspruch 1, wobei das Bestimmen umfasst zu bestimmen, dass der auf die Taste (400; 500; 600; 700; 800; 902; 904) gewirkte Druck ein Tastenanschlag ist, in Reaktion darauf, dass sowohl der auf die Taste gewirkte Druck auf den Tastendruckschwellbetrag ansteigt und dass eine Schwellenzeitspanne verstrichen ist, seit eine unterschiedliche Taste der Tastatur (900) vorher gedrückt wurde.

4. Verfahren nach Anspruch 1, wobei der Tastendruckschwellbetrag für unterschiedliche Tasten (902; 904) der Tastatur (900) variiert.

5. Verfahren nach Anspruch 1, ferner umfassend Identifizieren eines bestimmten Werts für den Tastendruckschwellbetrag für einen Benutzer als Teil eines Benutzeranpassungsprozesses.

6. Verfahren nach Anspruch 1, ferner umfassend Bestimmen des Tastendruckschwellbetrags zumindest teilweise basierend auf einer Auslegung der Datenverarbeitungsvorrichtung (102; 3402), einer Ausrichtung der Datenverarbeitungsvorrichtung und/oder einer Anwendung, die auf der Datenverarbeitungsvorrichtung ausgeführt wird.

7. Verfahren nach Anspruch 1, ferner umfassend Bestimmen, nach dem Bestimmen, dass der auf die Taste (400; 500; 600; 700; 800; 902; 904) gewirkte Druck ein Tastenanschlag ist, und basierend auf dem auf die Taste gewirkten Druck, einer Weise, in der ein der Taste entsprechendes Zeichen zu präsentieren ist und/oder einer Weise, in der Rückkopplung für den Benutzer in Reaktion auf den Tastenanschlag bereitzustellen ist.

## Revendications

1. Procédé comprenant les étapes consistant à :
obtenir une indication de la pression appliquée sur une touche (400 ; 500 ; 600 ; 700 ; 800 ; 902 ; 904) d'un clavier sensible à la pression (900) configuré pour pouvoir être retiré physiquement et exclus de la communication d'un dispositif informatique (102 ; 3402) ;
déterminer combien d'autres touches ont été enfoncées et sont encore enfoncées, une autre touche étant considérée comme étant enfoncée lorsque la pression exercée sur l'autre touche est égale ou supérieure à une valeur du seuil de pression d'actionnement de la touche ; et
déterminer que la pression appliquée à la touche est une frappe de touche lorsque la pression appliquée à la touche atteint une valeur du seuil de pression d'actionnement sur une touche et que le nombre des autres touches enfoncées simultanément ne dépasse pas une valeur de seuil.

2. Procédé selon la revendication 1, la détermination comprenant l'étape consistant à déterminer que la pression appliquée à la touche (400 ; 500 ; 600 ; 700 ; 800 ; 902 ; 904) est une frappe de touche à condition que la pression appliquée à la touche atteigne la valeur du seuil de pression d'actionnement de la touche et qu'en même temps un seuil de durée se soit écoulé depuis que la touche a été frappée auparavant puis relâchée.

3. Procédé selon la revendication 1, la détermination comprenant l'étape consistant à déterminer que la pression appliquée à la touche (400 ; 500 ; 600 ; 700 ; 800 ; 902 ; 904) est une frappe de touche à condition que la pression appliquée à la touche atteigne la valeur du seuil de pression d'actionnement de la touche et qu'en même temps un seuil de durée se soit écoulé depuis qu'une touche différente du clavier (900) a été frappée auparavant.

4. Procédé selon la revendication 1, dans lequel la valeur du seuil de pression d'actionnement de la touche varie pour différentes touches (902 ; 904) du clavier (900) .

5. Procédé selon la revendication 1, comprenant en outre l'identification d'une valeur particulière pour la valeur du seuil d'actionnement de la touche pour un utilisateur dans le cadre d'un processus de personnalisation en fonction de l'utilisateur.

6. Procédé selon la revendication 1, comprenant en outre la détermination de la valeur du seuil d'actionnement de la touche en fonction, au moins en partie, d'une configuration du dispositif informatique (102 ; 3402), d'une orientation du dispositif informatique et/ou d'une application en cours d'exécution sur le dispositif informatique.

7. Procédé selon la revendication 1, comprenant en outre l'étape consistant à déterminer, après avoir déterminé que la pression appliquée sur la touche (400 ; 500 ; 600 ; 700 ; 800 ; 902 ; 904) est une frappe de touche et en fonction de la pression appliquée à la touche, une façon de présenter un caractère correspondant à la touche et/ou de fournir à l'utilisateur un retour d'information en réponse à la frappe de la touche.
